Europäisches Patentamt

European Patent Office

Office européen des brevets

(19)

(11) Veröffentlichungsnummer: **0 427 884 B1**

## (12) EUROPÄISCHE PATENTSCHRIFT

(45) Veröffentlichungstag der Patentschrift: **13.04.94**

(51) Int. Cl.⁵: **H03M 7/42**

(21) Anmeldenummer: **89121100.5**

(22) Anmeldetag: **14.11.89**

(54) Verfahren und Anordnung zum Komprimieren und Dekomprimieren von Daten.

(43) Veröffentlichungstag der Anmeldung:
**22.05.91 Patentblatt 91/21**

(45) Bekanntmachung des Hinweises auf die
Patenterteilung:
**13.04.94 Patentblatt 94/15**

(84) Benannte Vertragsstaaten:
**AT BE CH DE ES FR GB IT LI NL SE**

(56) Entgegenhaltungen:
**EP-A- 0 286 719
US-A- 3 394 352
US-A- 4 626 829
US-A- 4 646 061
US-A- 4 730 348**

**IBM TECHNICAL DISCLOSURE BULLETIN,
Band 14, Nr. 3, August 1971, Seiten 874-876,
New York, US; A.J. ATRUBIN et al.: "Datacompression coding for character video
transmission"**

(73) Patentinhaber: **Siemens Nixdorf Informationssysteme Aktiengesellschaft
Fürstenallee 7
D-33102 Paderborn(DE)**

(72) Erfinder: **Bodamer, Edgar, Dipl.-Inf.
Karl-Witthalm-Strasse 30
D-8000 München 70(DE)**

(74) Vertreter: **Fuchs, Franz-Josef, Dr.-Ing. et al
Postfach 22 13 17
D-80503 München (DE)**

## Beschreibung

Die Erfindung betrifft ein Verfahren und eine Anordnung zum Komprimieren und Dekomprimieren von Daten entsprechend dem Oberbegriff der Patentansprüche 1 bzw. 11.

In üblicher Weise aus Zeichenfolgen gebildete Daten sind in hohem Maße redundant, d.h. sie enthalten eine wesentlich größere Anzahl von Elementen, als zur Darstellung der jeweils enthaltenen Information erforderlich wäre. Durch Ausnutzung dieser Redundanz infolge Komprimieren läßt sich daher die Übertragung von Daten oder deren Speicherung wirtschaftlicher gestalten, da dadurch die Übertragungszeit verkürzt bzw. der erforderliche Speicherbedarf verringert wird.

Es sind bereits eine Reihe von Verfahren zum Komprimieren und Dekomprimieren bekannt, die sich grob auf zwei Prinzipien zurückführen lassen. Das eine Prinzip beruht auf der Huffman-Codierung gemäß Proceedings of the IRE, September 1952, Seiten 1098 bis 1101, wobei die den Zeichen einer vorgegebenen Zeichenmenge entsprechenden Codezeichen fester Länge, z.B. 8 Bit, entsprechend der Häufigkeit ihrer Verwendung innerhalb der zu übertragenden oder abzuspeichernden Daten in Codezeichen variabler Länge umgewandelt und nach der Übertragung bzw. beim Lesen des Speichers daraus wieder die entsprechenden Codezeichen fester Länge gebildet werden.

Beim anderen Prinzip, das dem ersten Prinzip überlagert sein kann, werden übereinstimmende Strukturcharakteristiken innerhalb der Daten genutzt. So werden z.B. Folgen gleicher Zeichen in ein entsprechendes Steuerzeichen mit nachfolgendem Codezeichen für das entsprechende Zeichen und einer Kennzahl für die Anzahl der Wiederholungen dieses Zeichens umgewandelt.

Bei strukturierten Datensätzen oder bei Bildern werden außerdem einander entsprechende Zeichenstellen oder Bildpunkte miteinander verglichen und die Vergleichsergebnisse, meist Folgen gleicher Ergebnisse, komprimiert übertragen. Auch können Übereinstimmungen in den Zeichenspalten von Datensätzen für die Komprimierung genutzt werden - man siehe hierzu z.B. DE-PS 35 25 898.

Bei dem auf der Häufigkeitsverteilung der Zeichen in den Daten beruhenden Prinzip ist aber zu berücksichtigen, daß die Häufigkeitsverteilung der Zeichen abhängig von der Art der Daten vielfach unterschiedlich ist und ein gewählter Komprimierungscode daher nicht für jede Datenart gleich optimal geeignet ist. So weist z.B. ein englischer Text eine andere Häufigkeitsverteilung der einzelnen Buchstaben auf als der gleiche Text in einer anderen Sprache. Will man daher unterschiedliche Datenarten optimal komprimieren, dann muß für jede Datenart der jeweils dazu passende optimale Komprimierungscode gewählt werden.

Wählt man dabei eine 1:1 Zuordnung zwischen jedem eingegebenen Codezeichen fester Länge und einem komprimierten Codezeichen, dann ergeben sich ohne gesonderte Steuerungsmaßnahmen gegebenenfalls Mehrdeutigkeiten bei der Übersetzung - man siehe z.B. DE-OS 27 35 319 -.

Bei der Lösung gemäß der DE-PS 14 62 533 werden z.B. bei den verschiedene Häufigkeitsverteilungen aufweisenden Datenarten individuell zugeordnete Codierer verwendet, denen die zu komprimierenden Daten portionsweise gleichzeitig zugeleitet werden. Nach der Codierung der jeweiligen Datenportion wird dann überprüft, welcher Codierer das günstigste Ergebnis liefert. Dieses gelangt dann mit einem vorausgehenden Steuerzeichen, das im Empfänger die jeweilige Codierungsart kennzeichnet, zur Aussendung, so daß im Empfänger jeweils die zugehörige Decodierungsart gewählt werden kann. Das Steuerzeichen für die Umschaltung auf die jeweilige Decodierungsart beseitigt in diesem Falle die möglichen Mehrdeutigkeiten. Jedoch verlängert es die komprimierte Datenportion, so daß eine Umschaltung auf einen anderen Komprimierungscode nur dann erfolgt, wenn die Differenz zwischen den Ergebnissen beim gültigen und im jeweils neuen Codierungscode größer ist als die Länge des zusätzlichen Steuerzeichens.

Von Nachteil dabei ist die Beschränkung auf eine vorgegebene Datenportion und damit die nur in vorgegebenen Abständen mögliche Umschaltung auf eine andere Datenart, sowie die vorherige parallele Komprimierungscodierung und der damit verbundene Speicheraufwand für die Zwischenspeicherung der gleichzeitig erzeugten Komprimierungsergebnisse.

Bei der Lösung nach US-PS 4 730 348 werden abhängig von der jeweiligen Datenart ebenfalls unterschiedliche Codiertabellen und Decodiertabellen verwendet. Die Umschaltung von einer dieser Codiertabellen auf eine andere wird jeweils eingeleitet, wenn das Verhältnis zwischen der Anzahl der Bits für die Ursprungsdaten und der Anzahl für die zugehörigen komprimierten Daten einen vorgegebenen Wert von 2:1 unterschreitet. In diesem Falle werden der Reihe nach alle Codiertabellen für die Komprimierung verwendet und auf diejenige umgeschaltet, die ein besseres Verhältnis liefert. Außerdem wird mit der Umschaltung ein entsprechendes Steuerzeichen zur Umschaltung auf die entsprechende Dekomprimiertabelle beim Empfänger in den auszusendenden Datenstrom eingefügt.

Der Aufwand bei dieser Lösung ist zwar gegenüber der zuvor beschriebenen Lösung geringer, da die Komprimierung anhand der verschiedenen Codiertabellen nacheinander und nicht parallel erfolgt, also keine Parallelspeicherung erforderlich ist. Jedoch ist auch hierbei die Umschaltung an vorgegebene Datenportionen gebunden. Außerdem kann wesentlich mehr Zeit vergehen bis die günstigste Codiertabelle gefunden ist.

Aufgabe der Erfindung ist es daher, ein Verfahren und eine entsprechend arbeitende Anordnung zu schaffen, womit bei geringerem Aufwand schneller auf den Wechsel von einer Datenart zur anderen reagiert werden kann.

Dies wird bei dem Verfahren gemäß der Erfindung durch die kennzeichnenden Merkmale des Patentanspruchs 1 erreicht.

Danach wird für jedes mögliche Zeichen zunächst festgelegt, welcher der den einzelnen Datenarten zugeordnete Komprimierungscode am günstigsten ist, und dem Zeichen ein entsprechendes Kennzeichen zugeordnet. Ausgehend von dieser Festlegung wird für jedes zu komprimierende Zeichen das zugehörige Kennzeichen ermittelt und jeweils geprüft, ob die jeweils gültige Komprimierungscodierung der des ermittelten Kennzeichens entspricht. Ist dies nicht der Fall, dann wird auf die neue Komprimierungscodierung umgeschaltet und der Wechsel durch ein entsprechendes Steuerzeichen gekennzeichnet.

Auch hierbei ist es gemäß den Weiterbildungen entsprechend den Ansprüchen 2 und 3 vorteilhaft, daß eine Umschaltung auf eine andere Codierungsart erst vorgenommen wird, wenn die Kennzeichen für eine vorgegebene Anzahl von aufeinanderfolgenden Zeichen auf eine andere, günstigere Codierungsart verweisen.

Andere Weiterbildungen gemäß den Ansprüchen 4 bis 7 beziehen sich auf die Unterdrückung der Komprimierung als weitere Datenart, wenn keiner der Komprimierungscodes einen Vorteil ergibt, und auf die Ergänzung der datenartabhängigen Verfahren im Hinblick auf Zeichenwiederholungen und auf Wiederholungen von gleichen Zeichenfolgen in strukturierten Daten, wobei alle diese Arbeitsmodi durch individuelle Steuerzeichen mit nachfolgenden zusätzlichen Angaben bezüglich der Anzahl der Zeichen und gegebenenfalls des Abstandes gekennzeichnet werden.

Weitere Vorteile ergeben sich durch die Beschränkung der Huffman-Codierung allein auf die tatsächlich zu komprimierenden Datenzeichen und die Steuerzeichen entsprechend Anspruch 8 sowie durch die Bildung der Zeichen für die komprimierten Daten aus gleichlangen Teilzeichen entsprechend den Ansprüchen 9 und 10. Dies ermöglicht ein sicheres Erkennen der Steuerzeichen und durch das feste Teilzeichenraster in Verbindung mit der durch die Steuerzeichen jeweils gekennzeichneten Zeichenfolge einen einfachen Steuerungsablauf bei der Dekomprimierung.

Die Grundstruktur der gemäß der Erfindung ausgebildeten Anordnung ergibt sich aus Anspruch 11, wobei ein Kennungsspeicher die Ermittlung der jeweils günstigsten Datenart ermöglicht, die dann für die Auswahl der jeweils zugeordneten Bereiche im Codierungs-und Decodierungsspeicher dient. Durch Auswertung der Kennung mehrerer Datenzeichen mit einer zusätzlichen Entscheidungslogik gemäß Anspruch 12 werden zu häufige und damit den Komprimierungsgrad beeinträchtigende Wechsel der Datenart vermieden.

Neben der die Datenart ermittelnden Teilsteuerung sind gemäß den Ansprüchen 13 bis 16 weitere Teilsteuerungen für das Erkennen von Folgen gleicher Zeichen und von Wiederholungen gleicher Zeichenfolgen bei strukturierten Daten ergänzend möglich, wobei alle Teilsteuerungen mit einer gemeinsamen Komprimierungssteuerung zusammenarbeiten. Letztere wird anhand der von den Teilsteuerungen gelieferten Informationen tätig und stellt entsprechend dem jeweils angeforderten Arbeitsmodus die Zeichen für die komprimierten Daten zusammen, wobei ein zusätzlicher Zwischenspeicher bei der einen Datenart mit unterdrückter Komprimierung die vorherige Zählung der Zeichen zur Ermittlung der Längenangabe ermöglicht.

Die restlichen Ansprüche 17 bis 19 beziehen sich dagegen auf den Teil der Dekomprimierungsanordnung, wobei eine Dekomprimierungssteuerung die komprimierten Daten entgegennimmt und anhand der über den Decodierungsspeicher ermittelten Steuerzeichen den jeweiligen Arbeitsmodus wirksam werden läßt, indem entsprechend dem Aufbau der den Steuerzeichen zugeordneten Zeichenfolgen die einzelnen Zeichen der Auswertung zugeführt werden. Analog den Teilsteuerungen auf der Komprimierungsseite sind der Dekomprimierungssteuerung dann Teilsteuerungen für die Wiederholung gleicher Zeichen oder für die Wiederholung gleicher Zeichenfolgen nachgeschaltet, wobei in Verbindung mit der Teilsteuerung für die Erzeugung gleicher Zeichenfolgen wiederum ein Schieberegisterspeicher mit mehreren in Reihe geschalteten Schieberegistern zur Nachbildung der einzelnen Datenzeilen erforderlich ist.

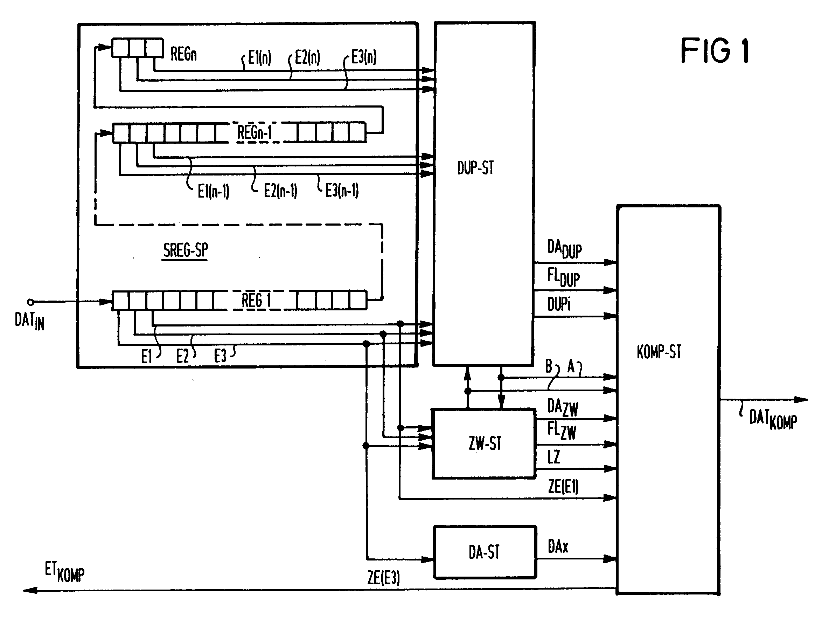

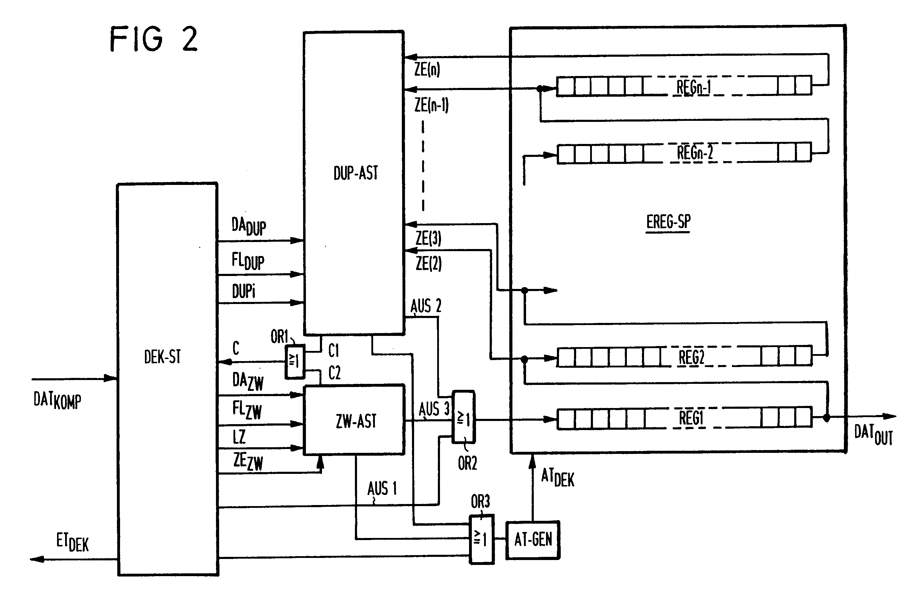

Einzelheiten der Erfindung seien nachfolgend anhand eines in der Zeichnung dargestellten Ausführungsbeispieles näher erläutert. Im einzelnen zeigen

FIG 1

ein Blockschaltbild einer gemäß der Erfindung arbeitenden Komprimierungsanordnung,

FIG 2

ein Blockschaltbild einer mit der Anordnung von FIG 1 zusammenarbeitenden Dekomprimierungsanordnung,

FIG 3

ein Codierungschema für die Anordnungen von FIG 1 und FIG 2,

FIG 4

den Aufbau der komprimierten Zeichenfolgen,

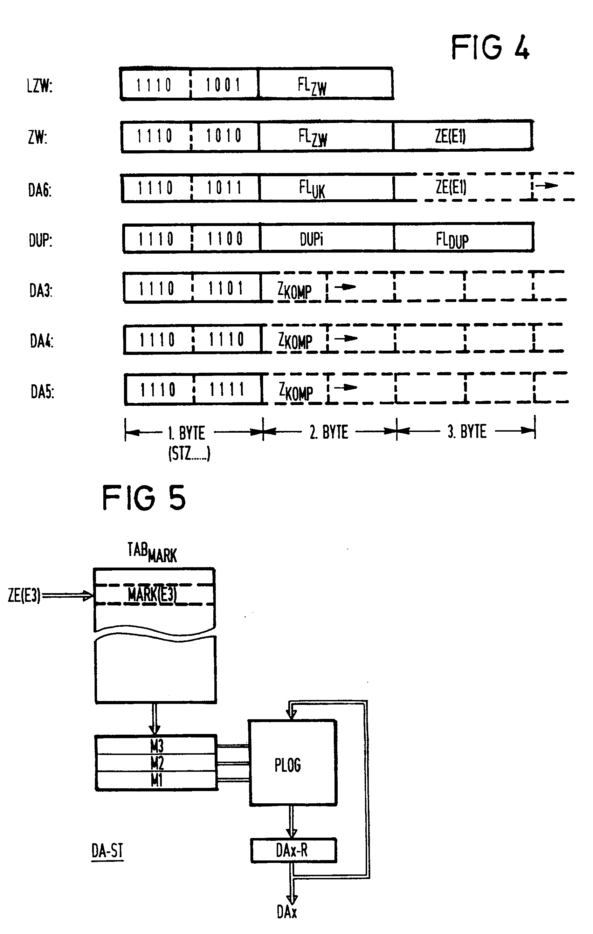

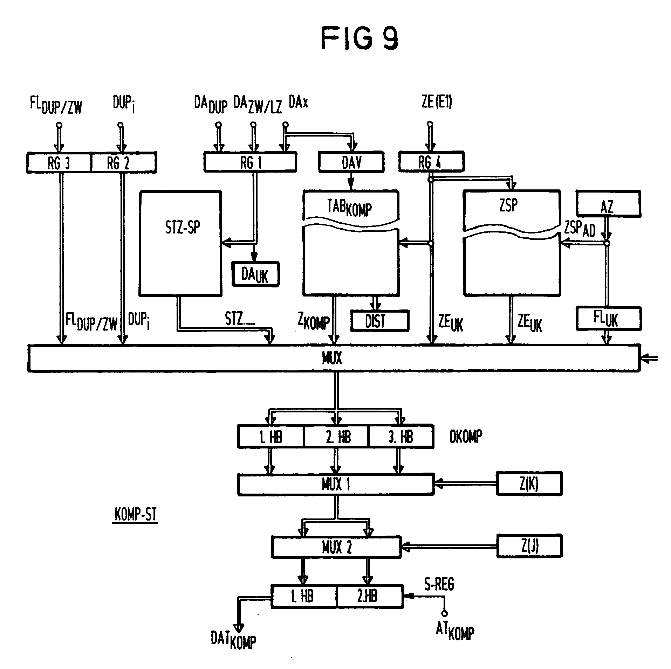

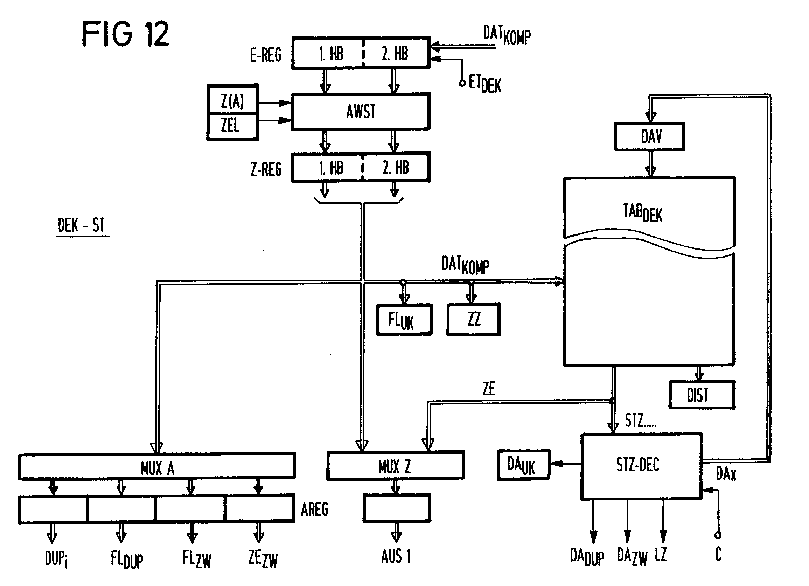

FIG 5
den strukturellen Aufbau der Datenartsteuerung von FIG 1 zur Ermittlung der günstigsten Datenart,
FIG 6
ein Flußdiagramm für den Steuerungsablauf der Datenartsteuerung von FIG 1 und FIG 5,
FIG 7
ein Flußdiagramm für den Steuerungsablauf der Zeichenwiederholungssteuerung von FIG 1,
FIG 8
ein Flußdiagramm für den Steuerungsablauf der Duplizersteuerung von FIG 1,
FIG 9
den strukturellen Aufbau der Komprimierungssteuerung von FIG 1,
FIG 10A bis FIG 10C
ein Flußdiagramm für den Steuerungsablauf der Komprimierungssteuerung von FIG 1 und FIG 9,
FIG 11
ein Flußdiagramm für die Zeichenausgabe der Komprimierungssteuerung von FIG 1,
FIG 12
den strukturellen Aufbau der Dekomprimierungssteuerung von FIG 2,
FIG 13A bis FIG 13C
ein Flußdiagramm für den Steuerungsablauf der Dekomprimierungssteuerung von FIG 2 und FIG 12,
FIG 14
ein Flußdiagramm für die Zeichenaufnahme durch die Dekomprimierungssteuerung von FIG 2,
FIG 15
ein Flußdiagramm für den Steuerungsablauf der Ausgabesteuerung für duplizierte Zeichen von FIG 2 und
FIG 16
ein Flußdiagramm für den Steuerungsablauf der Ausgabesteuerung für wiederholte Zeichen von FIG 2.

Das Blockschaltbild von FIG 1 zeigt eine Komprimierungsanordnung, bestehend aus einem von einem vorgeschalteten Pufferspeicher mit den zu komprimierenden Daten $DAT_{IN}$ ladbaren Schieberegisterspeicher SREG-SP, aus der Teilsteuerung DA-ST für die Ermittlung der jeweils die Komprimierung bestimmenden Datenart DAx, aus der Teilsteuerung ZW-ST für die Ermittlung von Folgen gleicher Zeichen bei einer Zeichenwiederholung ZW, aus der Teilsteuerung DUP-ST für die Erkennung wiederkehrender Zeichenfolgen bei strukturierten Daten und aus der eigentlichen Komprimierungssteuerung KOMP-ST für die Bereitstellung der komprimierten Daten $DAT_{KOMP}$ abhängig von den Ergebnissen der drei vorgeschalteten Teilsteuerungen.

Der Schieberegisterspeicher SREG-SP besteht aus mindestens einem Schieberegister REG1 vorgegebener Länge, in das die einzelnen Zeichen der zu komprimierenden Daten $DAT_{KOMP}$ einzeln nacheinander abhängig von einem von der Komprimierungssteuerung KOMP-ST gelieferten Eingabetakt $ET_{KOMP}$ eingeschoben werden. Die weiteren gezeigten Register bis REGn-1 und REGn, die alle in Reihe geschaltet sind, sind nur erforderlich, wenn es sich um strukturierte Daten, z.B. Datensätze, handelt, bei denen sich in verschiedenen Zeilen entsprechend den verschiedenen Registern REG1 bis REGn Zeichenfolgen wiederholen, so daß bei der Dekomprimierung auf die bereits dekomprimierte Zeichenfolge einer vorausgehenden Zeile zurückgegriffen und die wiederkehrende Zeichenfolge durch Duplizieren der vorangehenden Zeichenfolge ermittelt werden kann. Die Länge des letzten Registers REGn kann dabei auf die für die Auswertung der durch die Teilsteuerung DUP-ST bzw. ZW-ST notwendige Anzahl von Zeichen beschränkt sein. Im vorliegenden Fall sind es drei aufeinanderfolgende Zeichen aus den ersten drei Speicherabschnitten E1 bis E3 aller Schieberegister REG1 bis REGn.

Die von den einzelnen Teilsteuerungen DA-ST, ZW-ST und DUP-ST an die Komprimierungssteuerung KOMP-ST gelieferten Signale haben folgende Bedeutung:

| | |
|---|---|
| DAx: | Datenart, die die günstigste Komprimierung ergibt. |
| ZE(E1): | Zu komprimierendes Zeichen aus dem Speicherabschnitt E1 des Registers REG1. |
| $DA_{ZW}$: | Ein-Bit-Signal zur Kennzeichnung der Datenarten "Zeichenwiederholung". |
| $FL_{ZW}$: | Anzahl der aufeinanderfolgenden gleichen Zeichen einer Folge. |
| LZ: | Ein-Bit-Signal zur Kennzeichnung einer Folge von Leerzeichen. |
| $DA_{DUP}$: | Ein-Bit-Signal zur Kennzeichnung des Dupliziermodus. |
| $FL_{DUP}$: | Anzahl der übereinstimmenden Zeichen zweier übereinstimmender Zeichenfolgen. |
| $DUP_i$: | Kennzeichnung der i-ten Zeile, für die die Duplizierung vorzunehmen ist, |
| A: | Ein-Bit-Signal zur Ankündigung einer Anforderung durch die Teilsteuerung DUP-ST. |
| B: | Ein-Bit-Signal zur Ankündigung einer Anforderung durch die Teilsteuerung ZW-ST. |

Die Erzeugung dieser Signale und deren Verarbeitung durch die Komprimierungssteuerung KOMP-ST wird später erläutert werden.

FIG 2 zeigt ebenfalls in Form eines Blockschaltbildes das Gegenstück zur Komprimierungsanordnung von FIG 1, nämlich die Dekomprimierungsanordnung. Diese Anordnung besteht aus einer die komprimierten Daten $DAT_{KOMP}$ aus einem nicht gezeigten Pufferspeicher mit Eingabetakten $ET_{DEK}$ übernehmenden Dekomprimierungssteuerung DEK-ST, der eine Ausgabesteuerung ZW-AST für Zeichenwiederholungen und eine Ausgabesteuerung DUP-AST für zu duplizierende Zeichenfolgen nachgeschaltet ist, und einem Schieberegisterspeicher EREG-SP, der analog dem der Komprimierungsanordnung aufgebaut ist.

Die den Ausgabesteuerungen ZW-AST und DUP-AST von der Dekomprimierungssteuerung DEK-ST zugeführten Signale $DA_{DUP}$, $FL_{DUP}$, DUPi bzw. $DA_{ZW}$, $FL_{ZW}$, LZ und $ZE_{ZW}$ entsprechen denen bei der Komprimierungsanordnung von FIG 1, wobei das Signal C der Dekomprimierungssteuerung DEK-ST anzeigt, daß eine der Ausgabesteuerungen entsprechend den Signalen C1 oder C2 noch mit der Zeichenausgabe beschäftigt ist und sie selbst daher keine weiteren Zeichen ausgehen kann.

Die von der Dekomprimierungssteuerung DEK-ST über den Ausgang AUS1 oder von der Ausgabesteuerung ZW-AST über den Ausgang AUS3 oder von der Ausgabesteuerung DUP-AST über den Ausgang AUS2 gelieferten Zeichen werden über das ODER-Glied OR2 dem Eingang des ersten Schieberegisters REG1 zugeführt, wobei mit jedem Zeichen über das ODER-Glied OR3 der Ausgabetaktgenerator AT-GEN angestoßen wird und einen Ausgabetakt $AT_{DEK}$ liefert. Die am Ausgang dieses Registers REG1 herausgeschobenen dekomprimierten Daten $DAT_{OUT}$ stehen dann in der ursprünglichen Form für die weitere Verarbeitung zur Verfügung. Außerdem werden die einzelnen Zeichen in die mit dem Schieberegister REG2 beginnende Schieberegisterkette REG2 bis REGn-1 übernommen und die jeweils am Ausgang eines jeden Registers anstehenden Zeichen ZE(2) bis ZE(n) der Ausgabesteuerung DUP-AST parallel zur Auswahl und Weiterleitung zugeführt.

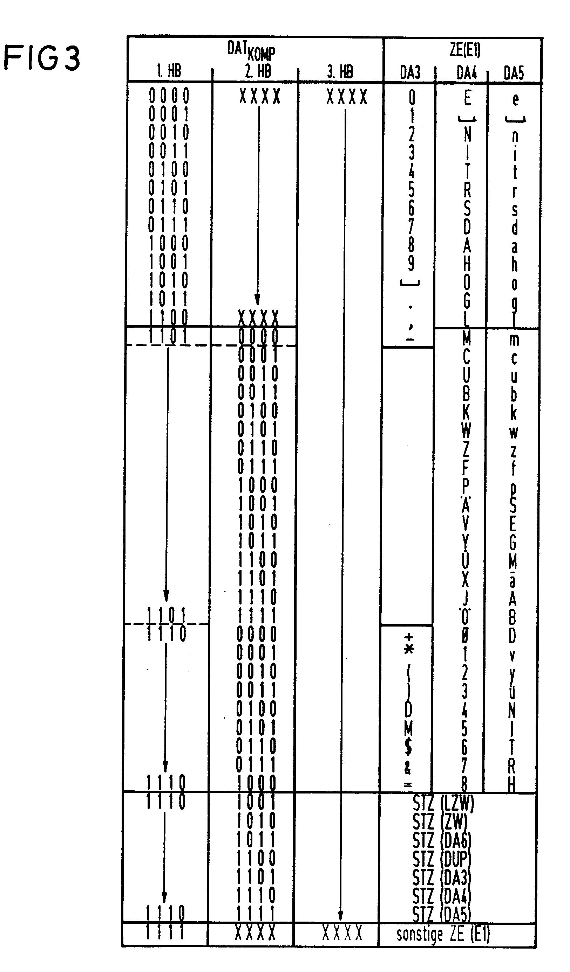

Bevor die Arbeitsweise der einzelnen Teilsteuerungen von FIG 1 und FIG 2 näher beschrieben wird, sei zunächst ein Beispiel des der Komprimierung und Dekomprimierung zugrundeliegenden Codierungsschemas entsprechend FIG 3 näher erläutert. Die gezeigte Tabelle zeigt im linken Teil die einzelnen Codekombinationen für die komprimierten Daten $DAT_{KOMP}$, wobei die einzelnen Codekombinationen aus einem, zwei oder gar drei Halbbytes 1.HB, 2.HB und 3.HB gebildet sein können. Der rechte Teil der Tabelle zeigt die den einzelnen Codekombinationen jeweils zugeordneten Zeichen ZE(E1), die als Zeichen ZE(E3) der Teilsteuerung DA-ST in FIG 1 zugeführt werden. Die einer Codekombination jeweils zugeordneten Zeichen sind abhängig von der Häufigkeitsverteilung der jeweiligen Datenart DA... unterschiedlich. Es werden dabei drei Datenarten DA3 bis DA5 unterschieden, nämlich rein numerische Zeichenfolgen (DA3), Zeichenfolgen aus Großbuchstaben (DA4) oder Zeichenfolgen gemischt aus Klein- und Großbuchstaben (DA5).

So werden beispielsweise bei der Datenart DA3 vierzehn Ein-Halbbyte-Zeichen und neun Zwei-Halbbyte-Zeichen und bei den Datenarten DA4 und DA5 jeweils dreizehn Ein-Halbbyte-Zeichen und fünfundzwanzig Zwei-Halbbyte-Zeichen verwendet, während alle übrigen Zeichen in der jeweiligen Datenart in Drei-Halbbyte-Zeichen umgewandelt werden, die durch die Kombination "1111" für das jeweils erste Halbbyte gekennzeichnet sind, an das jeweils die Codekombination des unkomprimierten Zeichens als zweites und drittes Halbbyte angehängt wird. Die restlichen Zwei-Halbbyte-Zeichen sind Steuerzeichen ST-Z... vorbehalten, die den jeweiligen Arbeitsmodus kennzeichnen. Es sind dies folgende Steuerzeichen:

STZ(LZW): Lehrzeichenwiederholung LZW
STZ(ZW): Zeichenwiederholung ZW
STZ(DA6): Unkomprimiert
STZ(DUP): Duplizieren DUP
STZ(DA3): Numerisch
STZ(DA4): Großbuchstaben
STZ(DA5): Klein- und Großbuchstaben gemischt.

FIG 4 zeigt die dem jeweiligen Arbeitsmodus entsprechenden Zeichenfolgen, wobei jeder Arbeitsmodus durch das entsprechende Steuerzeichen STZ... eingeleitet wird, das der Dekomprimierungsanordnung jeweils anzeigt, wie die nachfolgenden Bitfolgen zu behandeln sind und welche Bedeutung sie im Einzelfall haben. Auf das Steuerzeichen STZ... folgt bei der Zeichenwiederholung (LZW bzw. ZW) und bei der Übertragungsart "Unkomprimiert" (DA6) die Anzahl $FL_{ZW}$ bzw. $FL_{UK}$ der nachfolgenden Zeichen und dann gegebenenfalls das Zeichen bzw. die Zeichen ZE(E1) in unkomprimierter Form, während beim Duplizieren (DUP) zunächst die Zeilenangabe (DUPi) und dann abschließend die Anzahl ($FL_{DUP}$) der zu duplizierenden Zeichen folgt. Bei den übrigen Datenarten folgen auf das Steuerzeichen STZ... unmittelbar die entsprechend dem Codierungsschema von FIG 3 umgesetzten Zeichen, die aus einem, zwei oder drei Halbbyte bestehen können.

Beim gewählten Codierungsschema von FIG 3 ist abweichend von der bekannten Huffman-Codierung eine Codierung in Halbbyte-Stufen vorausgesetzt, was wegen des damit verbundenen starren Halbbyte-Rasters den Steuerungsablauf vereinfacht. Jedoch gelten auch hierfür die Bedingungen der Hufmann-Codierung, wobei zur Vermeidung von Mehrdeutigkeiten beim Arbeitsmodus "Unkomprimiert" (DA6) die Anzahl $FL_{UK}$ der unkomprimiert weitergeleiteten Zeichen im Anschluß an das Steuerzeichen (STZ) (DA6) übertragen wird. Die unkomprimierten Zeichen können dann kein Steuerzeichen vortäuschen.

In analoger Weise wäre auch ein nicht an ein Halbbyte-Raster gebundenes Codierungsschema möglich.

Für die Anzahl FL... der Zeichen einer Folge und den Zeilenabstand DUPi beim Duplizieren ist beim gewählten Beispiel jeweils 1 Byte zu 8 Bit vorgesehen, so daß bis zu 256 Zeichen einer Folge oder Datensätze mit bis zu 256 Zeilen erfaßt werden. Für DUPi könnte gegebenenfalls ein Halbbyte mit 4 Bit bei maximal 16 Zeilen genügen.

Eine Folge, die mehr als 256 Zeichen lang ist, wird in zwei oder mehrere Folgen mit jeweils einer Maximallänge von 256 Zeichen zerlegt. Das Steuerzeichen mit Längenangabe wird entsprechend oft wiederholt.

Da die Steuerzeichen SZ... und die Längenangaben FL... und DUPi keine Nutzdaten darstellen, verlängern sie in der üblichen Weise die jeweilige Datenportion. Beim Arbeitsmodus für Zeichenwiederholung (ZW), Unkomprimiert (DA6) und Duplizieren (DUP) sind im vorliegenden Fall wenigstens drei Byte erforderlich, um ein Nutzzeichen komprimiert darzustellen. Da ein unkomprimiertes Zeichen aber durch nur ein Byte dargestellt wird, ergibt sich ein Komprimierungseffekt erst ab drei Nutzzeichen. Demzufolge werden diese drei Arbeitsmodi erst wirksam, wenn eine entsprechende Anzahl von Nutzzeichen erfaßt wird. Die Angabe FL... kann daher nur die Werte 3 bis 256 umfassen. Entsprechend werden in FIG 1 jeweils die in die ersten drei Abschnitte E1 bis E3 der Register REG1 bis REGn eingespeicherten Zeichen von der Teilsteuerung DUP-ST bzw. ZW-ST ausgewertet.

Nachfolgend sei nun der Arbeitsablauf der einzelnen Teilsteuerungen von FIG 1 näher erläutert.

FIG 5 zeigt den strukturellen Aufbau der Teilsteuerung DA-ST für die Datenartermittlung. Wesentlicher Bestandteil ist eine Tabelle $TAB_{MARK}$, die für jedes zugeführte Zeichen ZE(E3) einen Eintrag enthält, der die die günstigsten bzw. gleichgünstige Komprimierungsergebnisse liefernde Datenart kennzeichnet. Jeder Eintrag MARK(E3) besteht daher für jede der Datenarten DA3 bis DA6 aus einem Bit, insgesamt also aus jeweils 4 Bit. Diese Einträge werden entsprechend der einlaufenden Zeichenfolge den Registern M3 bis M1 nacheinander zugeführt, so daß die Einträge jeweils dreier aufeinanderfolgender Zeichen spaltenweise durch eine Entscheidungslogik (PLOG) überprüft werden können. Davon abhängig wird dann ermittelt, welches die jeweils günstigste Datenart DAx ist und ob ein Wechsel der Datenart zweckmäßig erscheint. Das Ergebnis wird jeweils in einem Register DAx-R hinterlegt und von dort der Komprimierungssteuerung KOMP-ST zugeführt.

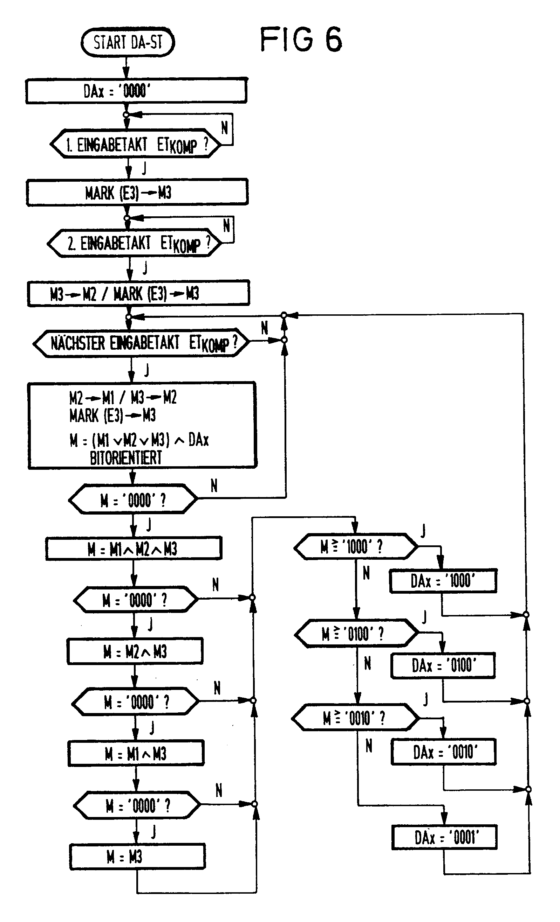

Aus dieser Funktionsstruktur ergibt sich dann der in FIG 6 dargestellte Arbeitsablauf für die Teilsteuerung DA-ST:
Nach dem Start und der Normierung des Wertes für die Datenart DAx im Register DAx-R von FIG 5 durch Einsetzen der Kombination "0000", die keiner der möglichen Datenarten entspricht, wird mit dem ersten Eingabetakt $ET_{KOMP}$ der Eintrag MARK-(E3) für das erste Zeichen ZE(E3) aus der Tabelle $TAB_{MARK}$ gelesen und ins Register M3 übertragen. Dieser Vorgang wiederholt sich für das zweite und das dritte Zeichen ZE(E3), wobei die Einträge im Register M3 jeweils zum nächsten Register M2 und von diesem zum Register M1 weitergeleitet werden. Nach dem dritten gelesenen Eintrag beginnt die Überprüfung durch die Prüflogik PLOG in FIG 5. Zunächst werden die Bitstellen der drei Einträge spaltenweise disjunktiv zusammengefaßt und die Ergebnisse konjunktiv mit der jeweils entsprechenden Bitstelle des Registers DAx-R verknüpft. Die vier Verknüpfungsergebnisse bilden dann das gesamte Ergebnis M. Weicht dies von der Kombination "0000" ab, dann ist bereits die günstigste Datenart DAx ermittelt und eine Änderung ist nicht erforderlich, so daß die Prüfung nach Eingabe des nächsten Zeichens wiederholt werden kann usw., bis sich die Kombination "0000" als Gesamtergebnis M ergibt.

Letzteres trifft wegen der Anfangskombination "0000" für die Datenart DAx nach jedem Start oder bei jedem notwendigen Wechsel der Datenart zu. In diesem Fall werden daher zunächst spaltenweise die Bitstellen aller drei Einträge in den Registern M1 bis M3 konjunktiv zusammengefaßt. Weicht das Ergebnis von der Kombination "0000" ab, ist bereits eine eindeutige Bestimmung der neuen Datenart DAx möglich, die dann entsprechend dem rechten unteren Zweig von FIG 6 ermittelt und durch eine "1" in der jeweiligen Bitstelle gekennzeichnet wird.

Weisen nicht alle drei Einträge auf die selbe Datenart hin, kann man eine Mehrheitsentscheidung entsprechend einem vorgegebenen Algorithmus herbeiführen. Beim gewählten Ausführungsbeispiel wird dann weitergeprüft, ob die letzten beiden Einträge aus den Registern M2 und M3 eine eindeutige Entscheidung zulassen. Schlägt diese Prüfung ebenfalls fehl, erfolgt die Prüfung anhand des ersten und letzten Eintrags aus den Registern M1 und M3 und schließlich die Bestimmung abhängig vom letzten Eintrag im Register M3.

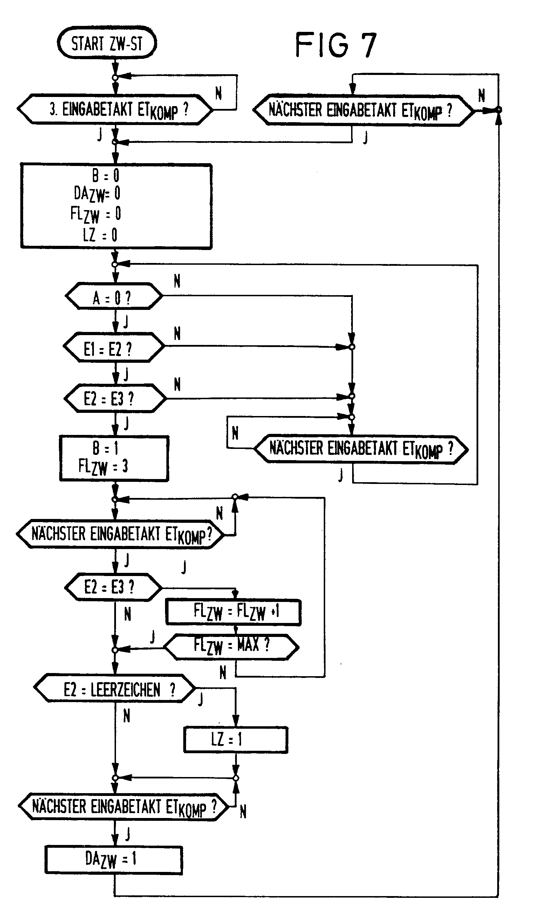

Die Arbeitsweise der Teilsteuerung ZW-ST für die Ermittlung von Zeichenwiederholungen ergibt sich in einfacher Weise aus dem Flußdiagramm von FIG 7. Danach werden nach dem Start zunächst drei Eingabetakte $ET_{KOMP}$ abgewartet, bis die Abschnitte E1 bis E3 im Register REG1 von FIG 1 mit den ersten drei zu komprimierenden Zeichen gefüllt sind. Außerdem werden alle Signale für die Komprimierungssteuerung KOMP-ST auf Null gesetzt.

Da der Dupliziermodus DUP Vorrang genießt, wird als erstes geprüft, ob A = 0 erfüllt ist. Ist dies nicht der Fall, wird die Prüfung nach jedem Eingabetakt $ET_{KOMP}$ wiederholt. Liegt keine Sperrung durch die Dupliziersteuerung DUP-ST vor, werden die Zeichen der Abschnitte E1 und E2 und dann der Abschnitte E2 und E3 jeweils auf Gleichheit überprüft.

Besteht in einem der Fälle keine Gleichheit, wird der jeweils nächste Eingabetakt $ET_{KOMP}$ und damit das nächste Zeichen abgewartet und die Prüfung wiederholt, bis in beiden Fällen Gleichheit gegeben ist, also alle drei überprüften Zeichen übereinstimmen.

Damit sind alle Voraussetzungen für den Arbeitsmodus "Zeichenwiederholung" (ZW) gegeben. Demzufolge wird das Signal B = 1 ausgelöst und die Anzahl $FL_{ZW}$ der übereinstimmenden Zeichen der Zeichenfolge auf den Wert "3" gesetzt.

Mit jedem weiteren Eingabetakt $ET_{KOMP}$ wird dann die Gleichheitsprüfung für die Abschnitte E2 und E3 des Registers REG1 wiederholt und bei Gleichheit der Wert für $FL_{ZW}$ um 1 erhöht, bis der Höchstwert MAX für $FL_{ZW}$ oder das Ende der Folge wegen Ungleichheit der überprüften Zeichen erreicht wird. Am Ende einer solchen Zeichenfolge wird dann anhand des letzten Zeichens der Folge geprüft, ob es sich um eine Leerzeichenfolge handelt. Ist dies der Fall, wird das Signal LZ = 1 ausgelöst, bevor mit dem nächsten Eingabetakt $ET_{KOMP}$ das letzte Zeichen der Folge in den Abschnitt E1 des Registers REG1 wandert und mit Setzen des Signales $DA_{ZW}$ = 1 für die Übernahme durch die Komprimierungssteuerung KOMP-ST freigegeben wird, so daß mit dem nächsten Eingabetakt $ET_{KOMP}$ der gesamte Prüfungsablauf von Neuem beginnen kann.

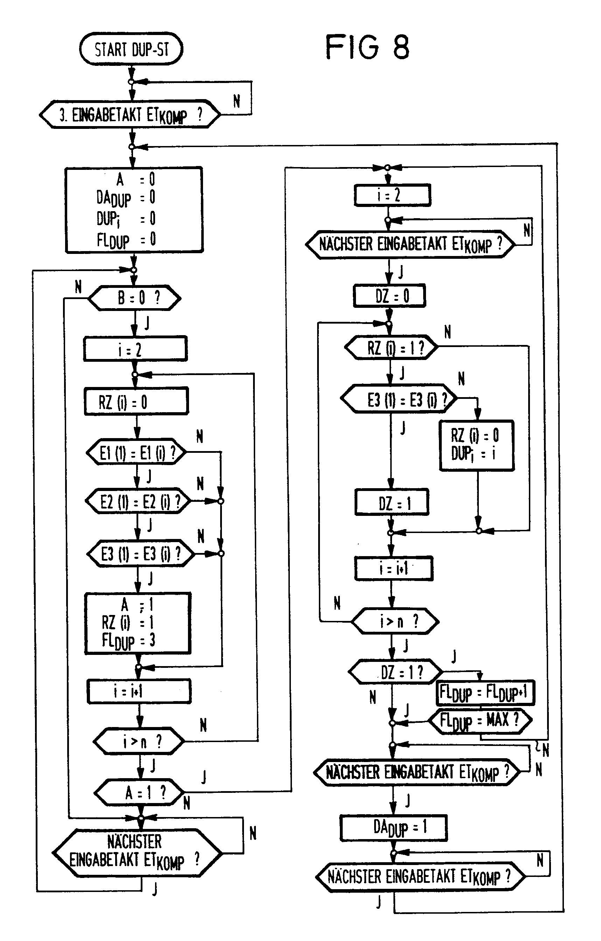

Wie bereits in Verbindung mit FIG 1 erläutert worden ist, überwacht die Dupliziersteuerung DUP-ST anhand der in den zusätzlichen Registern REG2 bis REGn gespeicherten Zeichen, ob eine ins Register REG1 eingespeicherte Zeichenfolge mit einer in den übrigen Registern des Schieberegisterspeichers SREG-SP identisch ist. Zu diesem Zweck werden die in den Abschnitten E1 bis E3 des ersten Registers REG1 jeweils befindlichen Zeichen nacheinander mit den Zeichen der entsprechenden Abschnitte der übrigen Register verglichen und bei Übereinstimmung ein registerindividueller Merker RZ(i) gesetzt, wobei der Index i = 2 bis n dem des zugehörigen Registers REGi entspricht. Außerdem verwendet die Teilsteuerung DUP-ST einen Merker DZ, der anzeigt, daß eine Übereinstimmung auch für die nachfolgend jeweils überprüfte Zeichenstelle einer Folge in einem der Register REGi gegeben ist. Unter dieser Voraussetzung ergibt sich gemäß FIG 8 folgender Steuerungsablauf für die Teilsteuerung DUP-ST:

Sobald nach dem dritten Eingabetakt $ET_{KOMP}$ die ersten drei Zeichen in den Abschnitten E1 bis E3 des Registers REG1 verfügbar sind, werden alle Signale A, $DA_{DUP}$, DUPi und $FL_{DUP}$ für die Komprimierungssteuerung KOMP-ST auf Null gesetzt. Liegt keine Sperrung durch die Teilsteuerung ZW-ST vor und gilt demzufolge B = 0, wird der Index i auf den Wert "2" gesetzt und damit das Register REG2 für den Zeichenvergleich freigegeben. Zuvor wird noch der zugehörige Merker RZ(i) auf Null gesetzt und durch diese Normierung die Vortäuschung einer Übereinstimmung verhindert. Besteht Übereinstimmung zwischen den verglichenen drei Zeichen aus dem Register REG1 und dem überprüften Register REGi, dann wird das Sperrsignal A = 1 erzeugt und der zugehörige Merker RZ(i) gesetzt. Außerdem wird entsprechend der übereinstimmenden Anzahl von Zeichen die Angabe $FL_{DUP}$ auf den Wert "3" eingestellt.

Der Prüfvorgang für das ausgewählte Register REGi ist damit beendet, und es wird durch Erhöhen des Index i um den Wert "1" - solange nicht das Register REGn überprüft ist - auf das nächstfolgende Register REGi + 1 umgeschaltet usw..

Nach Überprüfung aller Register REG2 bis REGn wird geprüft, ob für eines der Register eine Übereinstimmung vorlag und daher das Sperrsignal A = 1 wirksam ist. Ist dies nicht der Fall, wird der nächste Eingabetakt $ET_{KOMP}$ abgewartet und der gesamte bisherige Prüfvorgang für die nächste Zeichenkombination wiederholt. Ist dagegen das Sperrsignal A = 1 wirksam dann wird auf den im rechten Teil von FIG 8 dargestellten Steuerungsablauf übergeleitet, der sich auf die Überprüfung der Übereinstimmung ab dem vierten Zeichen einer Folge bezieht. Ausgangspunkt der weiteren Prüfung ist daher wieder das Register REG2 entsprechend dem Index i = 2, und die weitere Prüfung beginnt, sobald mit dem nächsten Eingabetakt $ET_{KOMP}$ das vierte Zeichen der Folge im Register REG1 verfügbar ist.

Auch in diesem Falle erfolgt durch Nullsetzen des Merkers DZ zunächst eine Normierung, da dieser Merker erst gesetzt werden darf, wenn für eines der Register REGi eine Übereinstimmung in der jeweils nachfolgend überprüften Zeichenstelle gegeben ist. Anschließend wird anhand des Merkers RZ(i) für das ausgewählte Register REGi jeweils geprüft, ob die vorangehenden Zeichen der Folge bereits übereinstimmten oder nicht. Ist der Merker nicht gesetzt, wird sofort durch Erhöhen des Index i um den Wert 1 auf das nächste Register REGi + 1 umgesteuert, bis das letzte Register REGn erreicht ist. Ist der Merker RZ(i) gesetzt, erfolgt der Zeichenvergleich für das neu eingegebene und sich im Abschnitt E3 befindliche Zeichen. Bei Zeichengleichheit wird der Merker DZ gesetzt und die Prüfung für das nächste Register REGi + 1 bis zum Erreichen des letzten Registers REGn fortgesetzt. Bei auftretender Zeichenungleichheit endet die Übereinstimmung der überprüften Zeichenfolge. Der Merker RZ(i) wird daher auf Null zurückgesetzt und der Wert für den eingestellten Index i als Wert für DUPi abgespeichert.

Sind alle Register überprüft und ist der Merker DZ gesetzt, dann bedeutet das, daß bis zur überprüften Zeichenstelle wenigstens in einem der Register eine gleiche Zeichenfolge vorhanden ist. Der Wert für die Angabe $FL_{DUP}$ wird daher um 1 erhöht, und solange der Wert den Höchstwert MAX, z.B. 256 bei 8 Bit, nicht erreicht hat, beginnt der Prüfzyklus für die jeweils nächste Zeichenstelle der Folge von neuem, wobei lediglich die Register überprüft werden, deren Merker RZ(i) noch gesetzt sind. Da bei jeder überprüften Zeichenstelle mit Beendigung der Übereinstimmung der Wert für DUPi neu eingestellt wird, kennzeichnet dieser Wert immer das Register REGi mit der längsten übereinstimmenden Zeichenfolge.

Wird schließlich im Rahmen der Überprüfung einer Zeichenstelle keine Übereinstimmung mehr gefunden und gilt daher DZ = 0, oder hat der Wert $FL_{DUP}$ den zulässigen Höchstwert MAX erreicht, dann wird die Überprüfung beendet und der nächste Eingabetakt $ET_{KOMP}$ abgewartet, damit das letzte übereinstimmende Zeichen der Folge aus dem Abschnitt E2 in den Abschnitt E1 im Register REG1 überführt wird. Danach wird mit $DA_{DUP}$ = 1 die Anforderung zur Übernahme der bereitstehenden Daten DUPi und $FL_{DUP}$ an die Komprimierungssteuerung KOMP-ST wirksam und mit dem nächsten nachfolgenden Eingabetakt $ET_{KOMP}$ wieder abgeschaltet. Aufgrund dieses Eingabetaktes wird auch das letzte Zeichen der übereinstimmenden Zeichenfolge aus dem Abschnitt E1 des Registers REG1 verdrängt, so daß alle Abschnitte E1 bis E3 mit neuen Zeichen gefüllt sind und unter Aufhebung des Sperrsignals A = 1 die Prüfung für eine neue Folge beginnen kann.

Die von den einzelnen Teilsteuerungen DA-ST, ZW-ST und DUP-ST gelieferten Signale $DA_{DUP}$, $DA_{ZW}$ und DAx werden von der Komprimierungssteuerung KOMP-ST laufend überwacht und ausgewertet. FIG 9 zeigt den strukturellen Aufbau dieser Teilsteuerung. Liegt eine Anforderung vor, werden die von den vorgeschalteten Teilsteuerungen jeweils gelieferten Informationen in Registern RG1 bis RG4 zwischengespeichert. Außerdem werden für die Ablaufsteuerung drei Speicher benötigt. Der erste Speicher STZ-SP beinhaltet die benötigten Steuerzeichen STZ..., die abhängig von den den jeweiligen Arbeitsmodus festlegenden Signalen $DA_{DUP}$,$DA_{ZW}$/LZ und DAx abrufbar sind. Der zweite Speicher $TAB_{KOMP}$ enthält die eigentliche Komprimierungstabelle gespeichert, die abhängig vom jeweiligen Zeichen ZE(E1) ansteuerbar ist und die jeweils aus dem der jeweiligen Datenart DAx entsprechenden Bereich das jeweils entsprechende komprimierte Zeichen $Z_{KOMP}$ undeine Angabe DIST über die Länge dieses Zeichens liefert. Bei der gewählten Halbbyte-Strukturierung bewegen sich diese Angaben zwischen den Werten 1 bis 3. Der Zweck dieser zusätzlichen Längenangabe wird später noch im Zusammenhang mit der Ausgabe der komprimierten Daten erläutert.

Der dritte Speicher ZSP dient schließlich als Zwischenspeicher für die einlaufenden Zeichen ZE-(E1) beim Arbeitsmodus "Unkomprimiert", bei dem die einlaufenden Zeichen als umkomprimierte Zeichen $ZE_{UK}$ weiterzuleiten sind, wenn die Zeichenanzahl $FL_{UK}$ der Folge ermittelt ist. Die Eingabe und Ausgabe für diesen Speicher ZSP erfolgt anhand zweier mit jedem Eingabetakt $ET_{KOMP}$ zyklisch fortschaltbarer Zähler $FL_{UK}$ und AZ, von denen der eine $FL_{UK}$ bei der Eingabe schrittweise fortgeschaltet wird und die Speicheradresse $ZSP_{AD}$ liefert, wobei der jeweils erreichte Endstand den Wert $FL_{UK}$ bildet. Bei der Ausgabe wird dagegen der Zähler AZ schrittweise fortgeschaltet und liefert die Speicheradresse $ZSP_{AD}$, wobei der Wert von $FL_{UK}$ das Ende der Ausspeicherung festlegt.

Alle für die Bildung der komprimierten Daten $DAT_{KOMP}$ benötigten Angaben aus den Registern und Speichern, nämlich $FL_{DUP/ZW}$,DUPi, $FL_{UK}$, STZ..., $Z_{KOM}$ und $ZE_{UK}$, sind über einen Auswahlschalter MUX an ein Bereitstellungsregister DKOMP weiterleitbar, das eine der Breite der längsten weiterzuleitenden Zeichen entsprechende Breite aufweist. Bei dem gemäß FIG 3 gewählten Codierungsschema sind dies drei Halbbyte für einen Teil der komprimierten Zeichen $Z_{KOMP}$ aus dem Speicher $TAB_{KOMP}$, während alle anderen Angaben allenfalls zwei Halbbyte umfassen.

Das Bereitstellungsregister DKOMP ist über eine z.B. aus zwei Auswahlschaltern MUX1 und MUX2 bestehende Auswahlsteuerung mit einem ein Byte breiten Senderegister S-REG gekoppelt, das immer mit zwei Halbbyte aufgefüllt wird, die dann mit einem Ausgabetakt $AT_{KOMP}$ als komprimierte Daten $DAT_{KOMP}$ weitergeleitet werden.

Die Einstellung der Übertragungspfade zwischen den einzelnen Halbbyte-Abschnitten 1.HB bis 3.HB im Bereitstellungsregister DKOMP und den beiden Halbbyte-Abschnitten 1.HB und 2.HB in Senderegister S-REG durch die beiden Auswahlschalter MUX1 und MUX2 ist dabei von den beiden Zeigern Z(K) bzw. Z(J) abhängig die durch die im übrigen nicht gezeigte Ablaufsteuerung jeweils eingestellt werden.

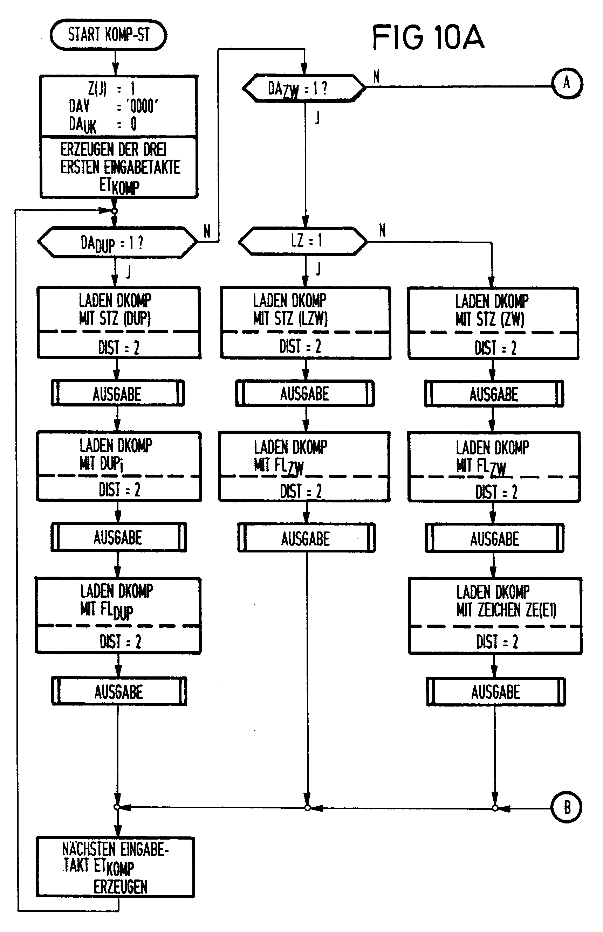

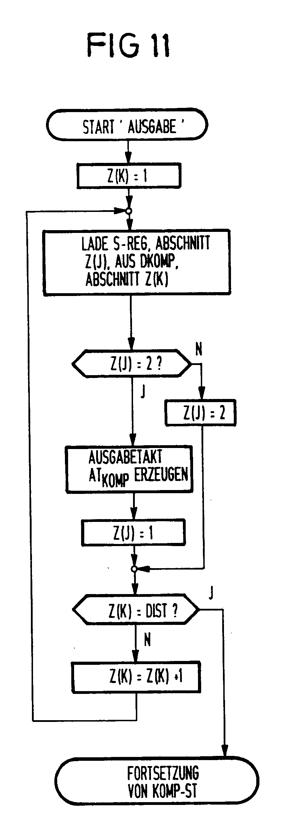

Die Arbeitsweise dieser Ablaufsteuerung ergibt sich aus den Flußdiagrammen von FIG 10A bis 10C und FIG 11, wobei letzteres sich auf die wiederholt benötigte Ausgaberoutine bezieht.

Nach dem Start der Komprimierungssteuerung KOMP-ST mit Setzen des Zeigers Z(J) auf "1", dem Laden der Kombination "0000" ins Register DAV und dem Setzen des Merkers $DA_{UK}$ auf "0" werden zunächst die ersten drei Eingabetakte $ET_{KOMP}$ für den Schieberegisterspeicher SREG-SP zur Übernahme der ersten drei Zeichen ins Register REG1 ausgelöst. Anschliessend werden die Arbeitsmodussignale $DA_{DUP}$, $DA_{ZW}$ und DAx fortlaufend überprüft.

Der Arbeitsmodus $DA_{DUP}$ genießt die höchste Priorität, dann folgt der Arbeitsmodus Zeichenwiederholung $DA_{ZW}$ und erst danach werden die anderen Arbeitsmodi entsprechend DAx berücksichtigt.

Im Falle eines Duplziervorganges entsprechend $DA_{DUP} = 1$ wird als erstes das Steuerzeichen STZ(DUP) ins Bereitstellungsregister DKOMP geladen und ausgegeben. Danach wiederholen sich diese Vorgänge für die Angabe DUPi und für die Angabe $FL_{DUP}$ entsprechend der in FIG 4 angegebenen Zeichenbildung beim Arbeitsmodus Duplizieren DUP.

Analoges gilt für die Arbeitsmodi Zeichenwiederholung ZW und Leerzeichenwiederholung LZW, wobei bei der einfachen Zeichenwiederholung ZW zusätzlich das entsprechende Zeichen ZE(E1) unkomprimiert ausgegeben wird.

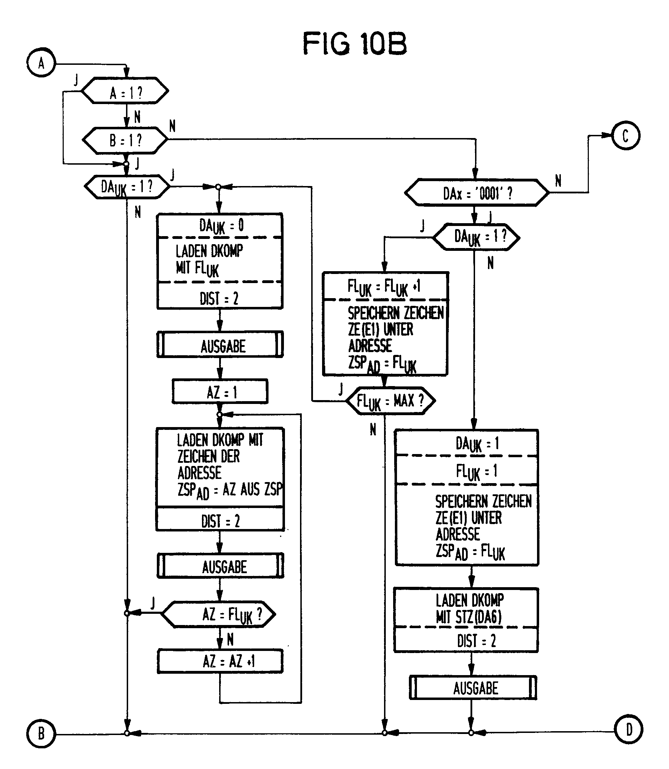

Erst wenn keiner dieser Arbeitsmodi angefordert wird und daher für beide Sperrsignale A = 0 und B = 0 (FIG 10B) gilt, können die übrigen Arbeitsmodi entsprechend DAx aufgerufen werden.

Entsprechend dem rechten Teil von FIG 10B wird dabei anhand der Angabe DAx geprüft, ob der Arbeitsmodus "Unkomprimiert" DA6 oder einer der übrigen Arbeitsmodi DA3 bis DA5 angefordert wird. Ist ersteres der Fall, wird ein Merker $DA_{UK}$ - falls noch nicht gesetzt - auf "1" gesetzt , der Zähler $FL_{UK}$ auf den Wert "1" eingestellt und das angelieferte Zeichen ZE(E1) im Speicher ZSP unter der vom Zähler $FL_{UK}$ gelieferten Adresse $ZSP_{AD}$ zwischengespeichert. Anschließend wird das aus dem Speicher STZ-SP ermittelte Steuerzeichen STZ-(DA6) ins Bereitstellungsregister DKOMP geladen und ausgegeben.

Da in diesem Falle der Wert $FL_{UK}$ erst am Ende einer unkomprimiert auszugebenden Zeichenfolge ermittelt werden kann, wird mit jedem weiteren Zeichen nach Setzen des Merkers $DA_{UK}$ nur der Wert für die Angabe $FL_{UK}$ um "1" erhöht und das Zeichen im Speicher ZSP zwischengespeichert, bis ein Wechsel des Arbeitsmodus angekündigt wird oder der Wert für $FL_{UK}$ den zulässigen Höchstwert MAX erreicht hat bzw. auf eine der Datenarten DA3 bis DA5 übergegangen wird.

Die Ankündigung eines Wechsels erfolgt bezüglich der Datenarten DUP bzw. ZW durch die Sperrsignale A = 1 bzw. B = 1. Ist gleichzeitig der Merker $DA_{UK}$ gesetzt, weil augenblicklich der Arbeitsmodus "Unkomprimiert" eingestellt ist, dann muß dieser Arbeitsmodus erst beendet werden, indem die Anzahl $FL_{UK}$ der unkomprimierten Zeichen und anschließend die im Speicher ZSP zwischengespeicherten Zeichen ausgegeben werden. Gemäß dem linken Teil von FIG 10B wird daher der Merker $DA_{UK}$ zurückgesetzt und die ermittelte Angabe $FL_{UK}$ ins Bereitstellungsregister DKOMP geladen und ausgegeben. Anschließend wird der Adressenzähler AZ für die Ausgabe der im Speicher ZSP gespeicherten unkomprimierten Zeichen $ZE_{UK}$ schrittweise weitergeschaltet und das jeweils gelesene Zeichen ausgegeben, bis der Zähler AZ den Wert der Angabe $FL_{UK}$ erreicht hat. Der gleiche Steuerungsablauf ergibt sich, wenn bei der Einspeicherung der umkomprimierten Zeichen $ZE_{UK}$ im Speicher ZSP gemäß dem rechten Teil von FIG 10B der Zähler $FL_{UK}$ den Höchstwert MAX erreicht hat.

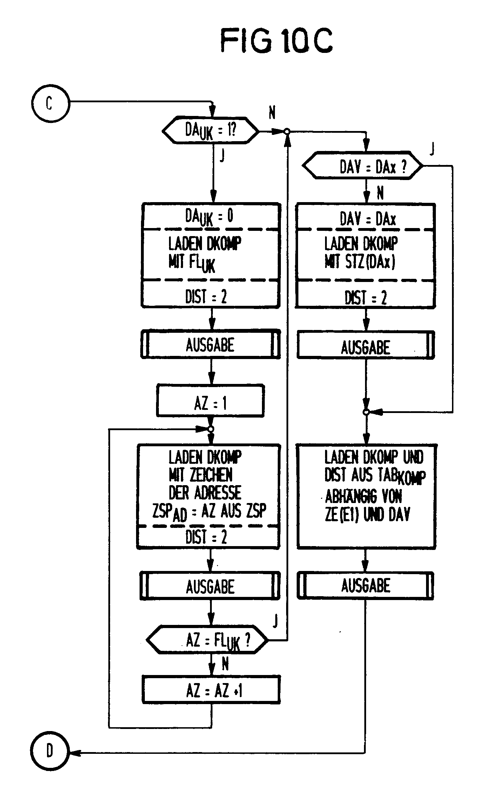

In gleicher Weise ist bei einem Wechsel zu einem der anderen Arbeitsmodi DA3 bis DA5 entsprechend FIG 10C zu prüfen, ob der Merker $DA_{UK}$ gesetzt ist oder nicht. Im ersteren Falle ergibt sich zunächst der zuvor beschriebene Steuerungsablauf. Allerdings wird nach dem Ausspeichern des letzten Zeichens der im Speicher ZSP zwischengespeicherten Zeichenfolge nicht der nächste Eingabetakt $ET_{KOMP}$ erzeugt, sondern auf die neue Datenart DAx umgeschaltet und beim jeweils ersten Zeichen der neuen Datenart das Register DAV entsprechend geladen. Außerdem wird das entsprechende Steuerzeichen STZ(DAx) gelesen und ausgegeben. Anschließend wird mit jedem für diese Datenart eingegebenen Zeichen ZE(E1) aus dem Speicher $TAB_{KOMP}$ das komprimierte Zeichen $ZE_{KOMP}$ aus dem der jeweiligen, im Register DAV abgespeicherten Datenart DAx zugeordneten Bereich gelesen und unmittelbar ausgegeben.

Das Flußdiagramm von FIG 11 gibt die bei jeder Ausgabe angestoßene Ausgaberoutine wieder.

Zu Beginn dieser Routine wird der Zeiger Z(K) für den Auswahlschalter MUX1 in FIG 9 auf den Wert "1" eingestellt, so daß zunächst das erste Halbbyte 1.HB aus dem Bereitstellungsregister DKOMP in das Senderegister S-REG zu übertragen ist. Da außerdem der Zeiger Z(J) für den Auswahlschalter MUX2 anfänglich ebenfalls auf den Wert "1" eingestellt ist (FIG 10A), wird vor Beginn der ersten Ausgabe immer der Abschnitt 1.HB des Bereitstellungsregisters DKOMP in den Abschnitt 1.HB des Senderegisters S-REG umgeladen. Bei der nachfolgenden Prüfung auf das Vorliegen von $Z(J) = 2$ ergibt sich daher zwangsläufig ein negatives Prüfergebnis, und der Zeiger $Z(J)$ wird auf den Wert "2" eingestellt. Anschließend wird anhand der vorgegebenen Zeichenlänge DIST dann geprüft, ob alle Halbbytes des im Bereitstellungsregister DKOMP bereitgestellten Zeichens, das zwischen ein und drei Halbbyte aufweisen kann, an das Senderegister S-REG übergeben sind. Bei einem Halbbyte-Zeichen entsprechend DIST = 1 bleibt der Abschnitt 2.HB des Senderegisters S-REG zunächst unbelegt, und es wird der unterbrochene steuerungsablauf der Komprimierungssteuerung KOMP-ST fortgesetzt.

Umfaßt das auszugebende Zeichen dagegen mehr als ein Halbbyte, z.B. zwei Halbbyte bei allen Steuerzeichen ST-Z..., dann wird der Zeiger $Z(K)$ um eine Einheit erhöht und das zweite Halbbyte aus dem Abschnitt 2.HB des Bereitstellungsregisters DKOMP in den Abschnitt 2.HB des Senderegisters S-REG geladen. Das Senderegister ist damit voll belegt, und es wird ein Ausgabetakt $AT_{KOMP}$ erzeugt.

Die Zeichenausgabe erfolgt somit immer byteweise, was zur Folge hat, daß immer erst zwei Halbbyte aus dem Bereitstellungsregister DKOMP ins Senderegister S-REG umgeladen werden müssen, gleichgültig, ob es sich um jeweils zwei Halbbyte desselben Zeichens oder zweier aufeinanderfolgender Zeichen handelt. Dabei ist jeder Halbbyte-Abschnitt 1.HB, 2.HB oder 3.HB des Bereitstellungsregisters DKOMP einzeln durch den Auswahlschalter MUX1 in Verbindung mit dem Zeiger $Z(K)$ auswählbar und jedem Halbbyte-Abschnitt 1.HB oder 2.HB des Senderegisters S-REG durch den Auswahlschalter MUX2 in Verbindung mit dem Zeiger $Z(J)$ zuführbar.

Die Dekomprimierungsanordnung gemäß FIG 2 arbeitet analog, nur in umgekehrter Richtung. FIG 12 zeigt den strukturellen Aufbau der zugehörigen Dekomprimierungssteuerung DEK-ST. Die Eingabesteuerung besteht aus einem ein Byte breiten Empfangsregister E-REG, dem die komprimierten Daten $DAT_{KOMP}$ aus einem vorgeschalteten Pufferspeicher mit Hilfe der Eingabetakte $ET_{DEK}$ in Byteportionen zugeführt werden, und einem ebenfalls ein Byte breiten Zwischenregister Z-REG. Die einzelnen Halbbyte-Abschnitte 1.HB und 2.HB beider Register sind durch eine Auswahlsteuerung AWST miteinander gekoppelt, die abhängig von den Zeigern $Z(A)$ und ZEL die Übertragungspfade zwischen den einzelnen Halbbyte-Abschnitten des Empfangsregisters E-REG und des Zwischenregisters Z-REG durchschalten, wobei der Zeiger ZEL zugleich eine Umladung vom Halbbyte-Abschnitt 2.HB des Zwischenregisters Z-REG in dessen anderen Halbbyte-Abschnitt 1.HB steuert, wie nachfolgend noch erläutert wird.

Am Ausgang des Zwischenregisters Z-REG steht somit für die Auswertung immer ein Ein-Byte-langes Zeichen zur Verfügung. Soweit es sich dabei um die Angaben $DUPi$, $FL_{DUP}$, $FL_{ZW}$ und das unkomprimierte Zeichen $ZE_{ZW}$ bei der Zeichenwiederholung ZW handelt, werden diese über einen Auswahlschalter MUXA den jeweils zugehörigen Schnittstellenregistern AREG für die nachgeschalteten Ausgabesteuerungen DUP-AST und ZW-AST von FIG 2 zugeführt. Gleiches gilt für die Zeichen beim Arbeitsmodus "Unkomprimiert" und für die übrigen unkomprimierten Zeichen, die über einen Auswahlschalter MUXZ unmittelbar weitergeleitet werden, während die Angabe $FL_{UK}$ einfach zwischengespeichert wird und als der das Ende der unkomprimierten Zeichenfolge anzeigende Vergleichswert für den Zeichenzähler ZZ dient, der mit jedem einlaufenden Zeichen einer unkomprimierten Zeichenfolge fortgeschaltet wird. Die Auswertung aller übrigen Zeichen der komprimierten Daten $DAT_{KOMP}$ erfolgt anhand des Speichers $TAB_{DEK}$, der zu jedem komprimierten Zeichen abhängig von der jeweils gültigen und im Register DAV hinterlegten Datenart DAx einen Eintrag gespeichert enthält. Diese Einträge bestehen aus dem jeweils zugehörigen dekomprimierten Zeichen ZE oder einem der Steuerzeichen STZ... sowie einer zugehörigen Längenangabe DIST des steuernden komprimierten Zeichens, anhand derer die Einstellung des Zeigers ZEL für die Auswahlsteuerung AWST überwacht wird. Das Eintragsschema für diesen Speicher $TAB_{DEK}$ entspricht dabei wiederum dem Codierungsschema von FIG 3.

Die aus dem Speicher $TAB_{DEK}$ gelesenen Zeichen werden jeweils einem Decodierer STZ-DEC zugeführt der das Vorliegen eines Steuerzeichens STZ... überwacht und bei Vorliegen eines Steuerzeichens die zugehörigen Steuersignale $DA_{DUP}$, $DA_{ZW}$ und LZ für die Ausgabesteuerungen DUP-AST bzw. ZW-AST liefert oder die jeweils gültige Datenart DAx anzeigt, die dann in das Register DAV eingespeichert wird. Ausgelesene dekomprimierte Zeichen ZE werden dagegen über den Auswahlschalter MUXZ einem den Ausgang AUS1 speisenden Schnittstellenregister AREG zugeführt.

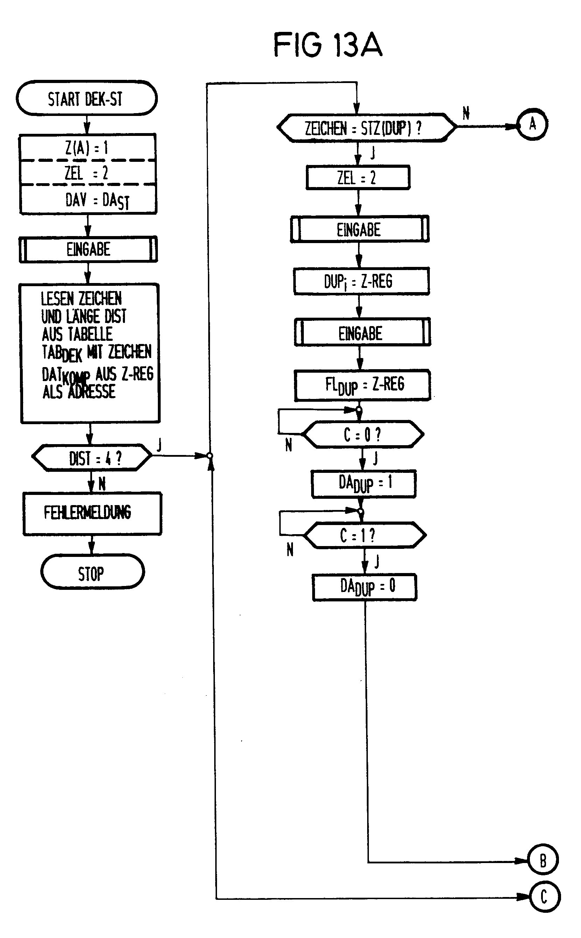

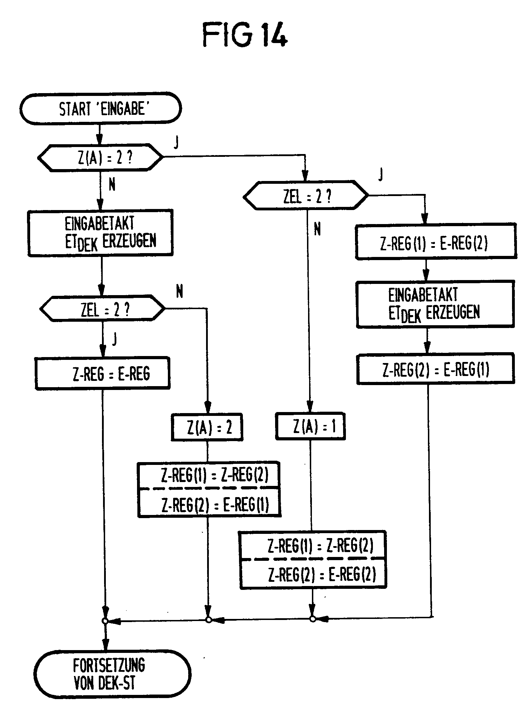

Aufgrund dieser Struktur ergibt sich der in FIG 13A bis FIG 13C und FIG 14 dargestellte Steuerungsablauf der Dekomprimierungssteuerung DEK-ST, wobei sich FIG 14 auf die wiederholt benötigte Eingaberoutine bezieht:
Nach dem Start der Dekomprimierungssteuerung DEK-ST gemäß FIG 13A wird zunächst der Zeiger $Z(A)$ auf den auf den Halbbyte-Abschnitt 1.HB verweisenden Wert "1" eingestellt und entsprechend dem zunächst zu erwartenden Steuerzeichen STZ... die Zeichenlänge ZEL = 2 entsprechend zwei Halbbyte vorgegeben. Außerdem wird unter der Voraussetzung, daß in jedem einer der Datenarten DA3 bis DA5 zugeordneten Speicherbereich des Speichers $TAB_{DEK}$ für alle Steuerzeichen ein Eintrag vorgesehen ist, eine dieser Datenarten als Startwert $DA_{ST}$ vorgegeben und im Register DAV hinterlegt. Danach erfolgt die Eingabe der ersten Ein-Byte-Datenportion in das Empfangsregister E-REG und anschließend die Übernahme in das steuernde Zwischenregister Z-REG von FIG 12, von dem aus dann der Speicher $TAB_{DEK}$ adressiert und der zugehörige Eintrag gelesen wird.

Abweichend von der tatsächlichen Länge der Steuerzeichen STZ... ist bei den Einträgen für die Steuerzeichen eine Länge entsprechend DIST = 4 angegeben, um so eine zusätzliche Kontrollmöglichkeit zu schaffen. Entspricht daher die gelesene Längenangabe DIST nach dem Start der Dekomprimierungssteuerung DEK-ST nicht dem Wert "4", so liegt ein Fehler vor, und es erfolgt eine Fehlermeldung mit Abbruch der Dekomprimierung.

Ist dagegen die gegebene Längenangabe gleich dem Wert "4", wird das gelesene Steuerzeichen STZ von der Decodiersteuerung STZ-DEC ausgewertet und davon abhängig der weitere Steuerungsablauf der Dekomprimierungssteuerung DEK-ST beeinflußt.

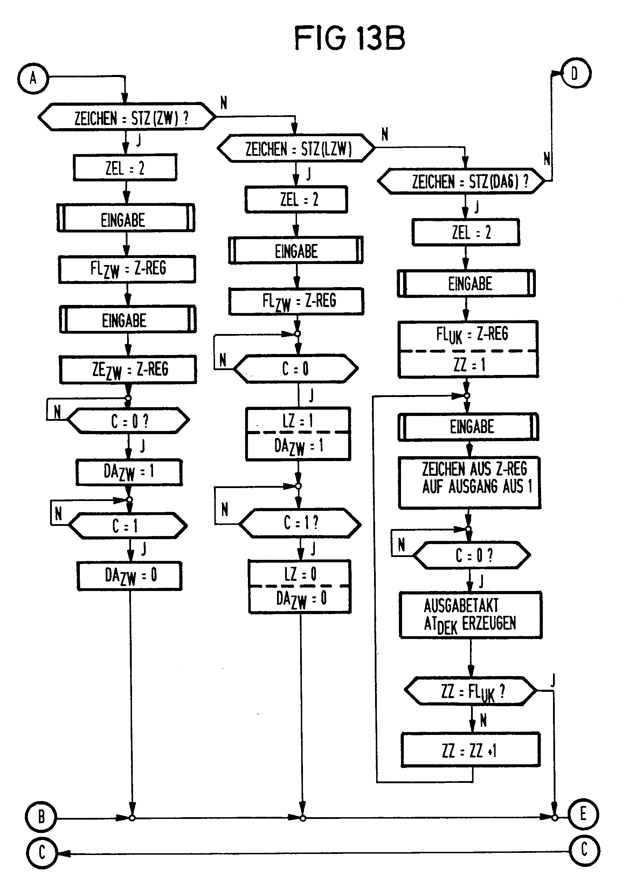

Handelt es sich um eine Duplizierung entsprechend dem Steuer zeichen STZ(DUP) wird gemäß dem rechten Teil von FIG 13A nach Einstellen des Zeigers ZEL auf die Zeichenlänge "2" die Eingabe für die Angaben DUPi und $FL_{DUP}$ veranlaßt, die aus dem Zwischenregister Z-REG jeweils in das zugehörige Schnittstellenregister AREG weitergeleitet werden. Damit stehen alle Steuergrößen für die Ausgabesteuerung DUP-AST bereit und es wird geprüft, ob die Ausgabe erfolgen kann, was durch das Signal C = 0 angezeigt wird. Ist die Ausgabe möglich wird das Anforderungssignal $DA_{DUP}$ = 1 gesetzt und damit die Ausgabesteuerung DUP-AST zur Übernahme der bereitstehenden Informationen aufgefordert. Nach Bestätigung der Übernahme mit dem Signal C = 1 wird das Anforderungssignal $DA_{DUP}$ wieder abgeschaltet. In analoger Weise reagiert die Dekomprimierungssteuerung bei den Steuerzeichen STZ(ZW) und STZ(LZW) entsprechend dem linken und dem mittleren Teil von FIG 13B. Nach Einstellung der Zeichenlänge ZEL = 2 wird zunächst die Angabe $FL_{ZW}$ bereitgestellt und zusätzlich beim Arbeitsmodus ZW das zu wiederholende Zeichen $ZE_{ZW}$. Danach wird, sobald die Ausgabe möglich ist, das entsprechende Anforderungssignal $DA_{ZW}$ = 1 erzeugt, wobei bei der Leerzeichenwiederholung LZW noch das Signal LZ = 1 hinzukommmt. Nach der Übernahme der Steuergrößen werden diese Signale wieder abgeschaltet.

Beim Arbeitsmodus "Unkomprimiert" entsprechend dem Steuerzeichen STZ(DA6) gemäß dem rechten Teil von FIG 13B gilt entsprechend der Länge der unkomprimierten Zeichen und der zugehörigen Steuerangabe $FL_{UK}$ ebenfalls ZEL = 2, wobei nach Eingabe und Zwischenspeicherung der Angabe $FL_{UK}$ der Zeichenzähler ZZ auf den Wert "1" gesetzt wird. Das mit jedem nachfolgenden Eingabevorgang im Zwischenregister Z-REG bereitgestellte unkomprimierte Zeichen wird dann unmittelbar über den Auswahlschalter MUXZ auf den Ausgang AUS1 weitergeleitet und mit einem dazu vom Taktgenerator AT-GEN erzeugten Ausgabetakt $AT_{DEK}$ an den Schieberegisterspeicher EREG-SP ausgegeben. Dieses Spiel wiederholt sich solange, bis der Zeichenzähler ZZ, der mit jeder Ausgabe um einen Schritt weitergeschaltet wird, den Wert der Angabe $FL_{UK}$ erreicht hat.

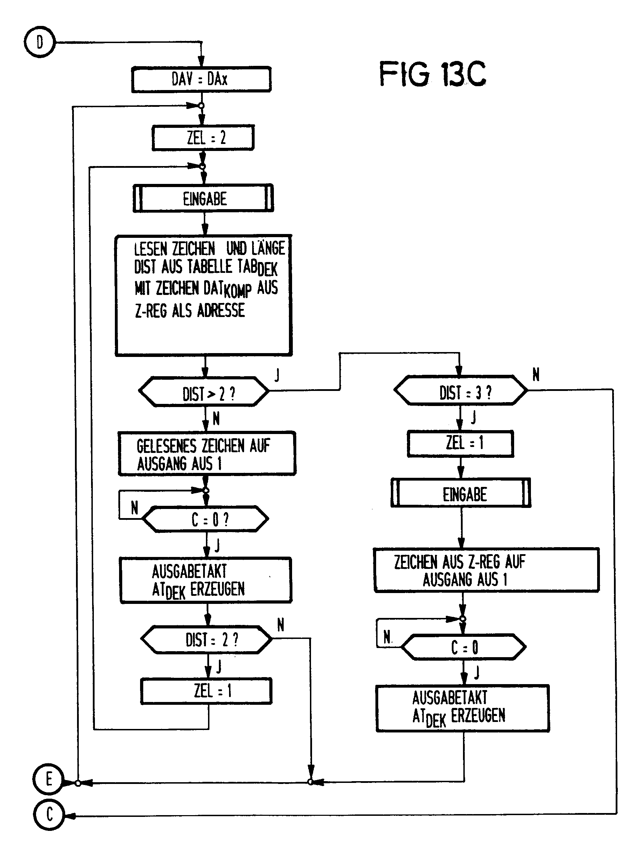

Am Ende der von den Steuerzeichen STZ-(DUP), STZ(ZW), STZ(LZW) und STZ(DA6) jeweils ausgelösten und vorangehend erläuterten Steuervorgänge wird über den Anschluß Ⓑ zum Anschluß Ⓔ für den in FIG 13C wiedergegebenen Steuerungsablauf übergeleitet, indem der Zeiger ZEL auf die Zeichenlänge entsprechend dem dann zu erwartenden nächsten Steuerzeichen eingestellt wird, so daß nach Übernahme eines zwei Halbbyte langen Zeichens in das Zwischenregister Z-REG der Speicher $TAB_{DEK}$ erneut gelesen und die Längenangabe DIST des gelesenen Eintrags überprüft werden kann.

Da einem Steuerzeichen, wie bereits erwähnt, die Längenangabe DIST = 4 zugeordnet ist, also DIST > 2 und DIST ≠ 3 gilt, wird über den Anschluß Ⓒ unmittelbar die Auswertung des gelesenen Steuerzeichens STZ in der bereits beschriebenen Weise eingeleitet.

Ergibt sich dabei, daß es sich um eine der Datenarten DA3 bis DA5 handelt, man also ausgehend von der Entscheidungskette im rechten oberen Teil von FIG 13A über den Anschluß Ⓐ für FIG 13B schließlich zum Anschluß Ⓓ für FIG 13C gelangt, dann wird die von der Decodiersteuerng STZ-DEC ermittelte Datenart DAx in das Register DAV übergeben und damit der zugehörige Speicherbereich im Speicher $TAB_{DEK}$ ausgewählt und die Längenangabe mit ZEL = 2 vorgegeben. Der nach der nachfolgenden Eingabe anhand des im Zwischenregisters Z-REG verfügbaren Zeichens $DAT_{KOMP}$ gelesene Eintrag wird dann wiederum bezüglich der Längenangabe DIST bewertet, da die komprimierten Zeichen eine Länge von einem bis drei Halbbyte aufweisen können.

Bei gültigen Zeichenlängen von Ein- oder Zwei Halbbyte des komprimierten Zeichens entsprechend DIST ≤ 2 liefert die Speicheransteuerung unmittelbar ein zugehöriges dekomprimiertes Zeichen ZE, das über den Auswahlschalter MUXZ an den Ausgang AUS1 weitergeleitet und auch ausgegeben werden kann, sobald C = 0 gilt. Anschließend wird anhand der Längenangabe DIST geprüft, ob nur ein oder beide Halbbyte im Zwischenregister Z-REG als Adresse für den Speicher TAB$_{DEK}$ für das Ergebnis entscheidend waren. Waren es zwei Halbbyte entsprechend DIST ≠ 1, wiederholt sich der gesamte Eingabe- und Auswertevorgang mit der bestehenden Längeneinstellung ZEL = 2. Wurde nur das erste Halbbyte verbraucht, wird auf die Längeneinstellung ZEL = 1 umgeschaltet, so daß das unverbrauchte Halbbyte im Zwischenregister Z-REG in den Abschnitt 1.HB umgeladen und der Abschnitt 2.HB mit dem ersten Halbbyte des nachfolgenden Bytes im Empfangsregister E-REG aufgefüllt wird, damit wiederum eine ein Byte lange Kombination im Zwischenregister Z-REG für die Ansteuerung des Speichers TAB$_{DEK}$ zur Verfügung steht.

Weist dagegen die aus dem Speicher TAB$_{DEK}$ gelesene Längenangabe DIST entsprechend DIST > 2 auf ein drei Halbbyte umfassendes komprimiertes Zeichen hin, dann beinhaltet der Abschnitt 1.HB im Zwischenregister Z-REG die Kombination "1111" als Hinweiszeichen für ein Drei-Halbbyte-Zeichen, bei dem dem ersten Halbbyte das unkomprimierte Zeichen folgt. Durch Umschalten auf die Längenangabe ZEL = 1 wird mit der nachfolgenden Eingabe durch Verschieben im Zwischenregister Z-REG und durch Auffüllen des Abschnittes 2.HB das unkomprimierte Zeichen vervollständigt, so daß es anschließend in der bereits beschriebenen Weise über den Ausgang AUS1 bei Vorliegen des Signals C = 0 mit dem dann erzeugten Ausgabetakt AT$_{DEK}$ ausgegeben werden kann. Anschliessend wird die nächste Ein-Byte-Kombination im Zwischenregister Z-REG bei einer Längeneinstellung ZEL = 2 bereitgestellt, und der in FIG 13C dargestellte Steuerzyklus beginnt von neuem, bis ein neues Steuerzeichen STZ... entsprechend DIST > 3 erkannt wird.

Das Flußdiagramm von FIG 14 gibt die vorangehend schon mehrfach angesprochene Eingaberoutine wieder, die mit einem Eingabetakt ET$_{DEK}$ jeweils 1 Byte der komprimierten Daten DAT$_{KOMP}$ in das Empfangsregister E-REG eingibt und anhand der Zeiger Z(A) und ZEL die Einstellung der Auswahlsteuerung AWST und damit die Füllung des Zwischenregisters Z-REG steuert.

Der Zeiger Z(A) bezeichnet mit seiner Einstellung "1" bzw. "2" jeweils immer den Halbbyte-Abschnitt 1.HB bzw. 2.HB, der als nächster ins Zwischenregister Z-REG zu übertragen ist, während der Längenzeiger ZEL mit seiner Einstellung "1" oder "2" anzeigt, ob beide Halbbyte-Abschnitte aus dem Empfangsregister parallel ins Zwischenregister zu übertragen sind oder ob nur ein Halbbyte in den Abschnitt 2.HB des Zwischenregisters Z-REG zu übergeben ist, wobei die in diesem Abschnitt befindliche Information vorher in den Abschnitt 1.HB übertragen wird.

Bei der ersten Eingabe nach dem Start der Dekomprimierungssteuerung DEK-ST gilt zunächst Z(A) = 1 und ZEL = 2, so daß wegen Z(A) ≠ 2 zunächst ein Eingabetakt ET$_{DEK}$ erzeugt werden muß, um das Empfangsregister E-REG mit dem ersten Byte der komprimierten Daten DAT$_{KOMP}$ zu laden. Wegen ZEL = 2 wird nun der gesamte Inhalt des Registers E-REG parallel ins Zwischenregister Z-REG übertragen, und die Dekomprimierungssteuerung DEK-ST kann den für die Eingabe unterbrochenen Steuerungsablauf von FIG 13A bis FIG 13C fortsetzen.

Gilt andererseits ZEL ≠ 2, weil nur das Halbbyte des Abschnittes 1.HB im Zwischenregister Z-REG verbraucht wurde, dann wird der Zeiger Z(A) auf den Wert "2" eingestellt, da von dem vorher wirksamen Eingabetakt ET$_{DEK}$ ein weiteres Byte der komprimierten Daten DAT$_{KOMP}$ ins Empfangsregister E-REG übernommen wurde, von dem aber nur das erste Halbbyte aus dem Abschnitt 1.HB zum Auffüllen des Zwischenregisters Z-REG benötigt wird, so daß das zweite Halbbyte im Abschnitt 2.HB noch zu berücksichtigen ist. Demzufolge wird anschließend die Kombination aus dem Abschnitt 2.HB des Zwischenregisters Z-REG zunächst in den Abschnitt 1.HB übertragen und danach der Abschnitt 2.HB aus dem Abschnitt 1.HB des Empfangsregisters E-REG aufgefüllt.

Analoges gilt für die Zeigerstellung Z(A) = 2 und ZEL = 1, allerdings mit dem Unterschied, daß dann eine Umschaltung auf die Zeigerstellung Z(A) = 1 erfolgt und der Abschnitt 2.HB des Zwischenregisters Z-REG aus dem Abschnitt 2.HB des Empfangsregisters E-REG aufgefüllt wird.

Bei den Zeigerstellungen Z(A) = 2 und ZEL = 2 ist der Inhalt des Zwischenregisters Z-REG vollkommen verbraucht, so daß zwei Halbbytes aus dem Empfangsregister E-REG zu übernehmen sind, die aber wegen des Hinweises des Zeigers Z(A) auf den Abschnitt 2.HB entsprechend Z(A) = 2 zwei aufeinanderfolgenden Bytes der komprimierten Daten DAT$_{KOMP}$ angehören. Demzufolge wird zunächst das verfügbare zweite Halbbyte aus dem Abschnitt 2.HB des Empfangsregisters E-REG ins Zwischenregister Z-REG übertragen und dann ein erneuter Eingabetakt ET$_{DEK}$ ausgelöst, damit das nachfolgende Byte der komprimierten Daten DAT$_{KOMP}$ ins Empfangsregister E-REG geladen wird, bevor der Abschnitt 2.HB im Zwischenregister Z-REG aus dem Abschnitt 1.HB des Empfangsregisters E-REG aufgefüllt und der unterbrochene Steuerungsablauf der Dekomprimierungssteuerung DEK-ST, wie bereits erläutert, fortgesetzt werden kann.

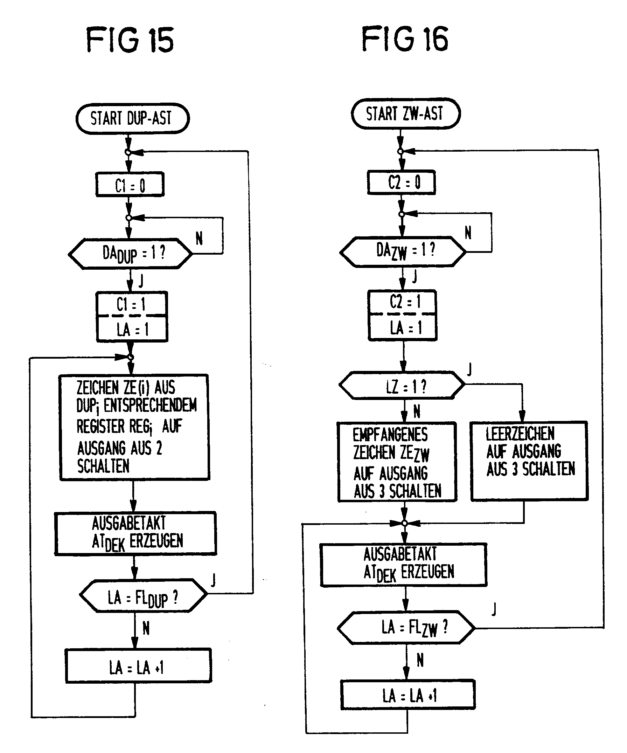

Der Steuerungsablauf für die nachgeschaltete Ausgabesteuerung DUP-AST von FIG 2 ergibt sich aus dem Flußdiagramm von FIG 15. Diese Ausgabesteuerung kann nach ihrem Start mit Einstellung des Signals C1 = 0 nur tätig werden, wenn eine Anforderung $DA_{DUP} = 1$ für sie vorliegt. Ist dies der Fall, werden die bereitgestellten Schnittstelleninformationen DUPi und $FL_{DUP}$ übernommen und als Quittung das Signal C1 = 1 erzeugt, das über das ODER-Glied OR1 von FIG 2 zum Signal C = 1 führt. Außerdem wird ein Längenzähler LA auf den Anfangswert "1" eingestellt. Entsprechend der Angabe DUPi wird dann das vom Register REGi gelieferte Zeichen ZE(i) unmittelbar auf den Ausgang AUS2 geschaltet und ein Ausgabetakt $AT_{DEK}$ erzeugt, mit dem das Zeichen über das ODER-Glied OR2 in das erste Register REG1 des Schieberegisterspeichers EREG-SP eingegeben wird. Anschließend wird geprüft, ob der Zähler LA den vorgegebenen Wert $FL_{DUP}$ erreicht hat. Solange dies nicht der Fall ist, wird der Zählerstand des Zählers LA jeweils um eine Zähleinheit erhöht und das mit dem Ausgabetakt $AT_{DEK}$ jeweils bereitgestellte nächste Zeichen ZE(i) ausgegeben, bis LA = $FL_{DUP}$ gilt und damit das Sperrsignal C1 = 1 wieder gelöscht wird.

In analoger Weise arbeitet die Ausgabesteuerung ZW-AST bei einer Zeichenwiederholung. Der zugehörige Steuerungsablauf ergibt sich aus dem Flußdiagramm von FIG 16. An die Stelle des Signals C1 tritt dabei das Signal C2, und eine Anforderung wird mit $DA_{ZW} = 1$ ausgelöst. Handelt es sich dabei um eine Leerzeichenwiederholung entsprechend LZ = 1, wird das Leerzeichen auf den Ausgang AUS3 geschaltet. Im anderen Falle wird das empfangene Zeichen $ZE_{ZW}$ durchgeschaltet. Mit einem nachfolgend erzeugten Ausgabetakt $AT_{DEK}$ erfolgt dann wiederum die Übergabe des jeweils bereitgestellten Wiederholungszeichens an das Register REG1 des Schieberegisterspeichers EREG-SP. Der Ausgabetakt $AT_{DEK}$ wird dann solange wiederholt, bis der jeweils um eine Zähleinheit erhöhte Zählerstand des Zählers LA den Wert der Angabe $FL_{ZW}$ erreicht hat, was dann ebenfalls zum Löschen des Sperrsignals C2 = 1 führt.

Die im Zusammenhang mit dem vorangehenden Ausführungsbeispiel anhand der einzelnen Flußdiagramme erläuterten Steuerungsabläufe können je nach Art ihrer Realisierung mit fest verdrahteter oder speicherprogrammierbarer Logik in der einen oder anderen Richtung abgewandelt werden, indem z.B. aufeinanderfolgende Schiebe- oder Vergleichsvorgänge parallel statt seriell nacheinander ausgeführt werden usw.. Auch ist die Erfindung nicht an das dem Codierungsschema von FIG 3 zugrundegelegte und damit den Ausgabevorgang bei der Komprimierung sowie den Eingabevorgang bei der Dekomprimierung entsprechend beeinflussende Halbbyteraster gebunden. Zwar vereinfacht und beschleunigt es den Steuerungsablauf, insbesondere bei speicherprogrammierter Steuerung, jedoch ist der erreichbare Komprimierungsgrad geringer als bei einer Codierung mit vom Halbbyteraster abweichender und unterschiedlicher Anzahl der für ein Codezeichen benötigten Bitstellen. Der Steuerungsablauf würde jedoch komplexer und aufwendiger. Auch wäre eine solche Lösung eher für eine fest verdrahtete Realisierung geeignet. Weiterhin kann die Festlegung der einzelnen Datenarten und die Zuordnung der Zeichen zu den Codezeichen abhängig von der Häufigkeitsverteilung je nach Anwendungsfall abweichend vom gewählten Ausführungsbeispiel getroffen werden, z.B. können unterschiedliche Sprachen berücksichtigt werden.

**Patentansprüche**

1. Verfahren zum Komprimieren und Dekomprimieren von Daten durch Umwandlung der die Daten bildenden und aus Bitfolgen konstanter Länge bestehenden Zeichen (ZE(E1)) in Bitfolgen mit unterschiedlicher Länge und umgekehrt, wobei sich die Länge der Bitfolgen für die umgewandelten Zeichen ($DAT_{KOMP}$) nach der statistischen Häufigkeitsverteilung des Auftretens der Zeichen bei der jeweils zugrundeliegenden Datenart (DA3...DA5) richet (Huffman-Codierung) und wobei zur Komprimierung von Daten für die einzelnen Zeichen jeweils mehrere, den einzelnen möglichen Datenarten zugeordnete umgewandelte Zeichen zur Verfügung stehen, von denen jeweils die umgewandelten Zeichen der die jeweils günstigsten Übertragungs- bzw. Speicherbedingungen ergebenden Datenart verwendet werden, wobei ein die jeweilige Datenart kennzeichnendes Steuerzeichen den jeweils umgewandelten Zeichen vorangestellt wird, das bei der Dekomprimierung die Wahl der zuständigen Datenart ermöglicht,

   **dadurch gekennzeichnet,**
   - daß jedem möglichen Zeichen (ZE(E3)) der zur Komprimierung anstehenden Daten ein Kennzeichen (MARK(E3)) zugeordnet wird, das die das günstigste Komprimierungsergebnis ergebende Datenart (DAx) kennzeichnet,
   - daß für jedes zu komprimierende Zeichen (ZE(E3)) das zugeordnete Kennzeichen (MARK(E3)) für die zugehörige günstigste Datenart (DAx) ermittelt wird,
   - daß anhand der jeweils ermittelten Kennzeichen fortlaufend überprüft wird, ob die der augenblicklichen Komprimierung zugrundegelegte Datenart (z.B. DA6) mit der durch die Kennzeichen angegebenen Datenart (z.B. DA5) übereinstimmt, und
   - daß bei einer Abweichung die durch die Kennzeichen angegebene Datenart (z.B. DA5) der weiteren Komprimierung zugrundegelegt wird.

2. Verfahren nach Anspruch 1, **dadurch gekennzeichnet,** daß der Wechsel auf eine der Komprimierung zugrundezulegende andere Datenart (DAx) erst nach Ermittlung einer vorgegebenen Anzahl (z.B. drei) von eine günstigere Datenart angebenden aufeinanderfolgenden Kennzeichen (MARK(E3)) erfolgt.

3. Verfahren nach Anspruch 2, **dadurch gekennzeichnet,** daß für die Kennzeichen (MARK(E3)) Bitkombinationen (z.B. "0010") mit einer der Anzahl (z.B. vier) der verschiedenen Datenarten (DA3 bis DA6) entsprechenden Anzahl (4) von Bitstellen verwendet und die der jeweils günstigsten Datenart (z.B. DA5) bzw. den jeweils gleichgünstigsten Datenarten entsprechenden Bitstellen (z.B. dritte Bitstelle) durch einen der beiden Binärwerte (z.B. "1") gekennzeichnet werden, daß je Bitstelle (z.B. dritte Bitstelle) die durch aufeinanderfolgende Zeichen (ZE(E3)) sich ergebende Folge von Binärwerten (z.B. "011") überwacht und anhand einer vorgegebenen Entscheidungslogik die Folge von Binärwerten ermittelt wird, die der günstigsten Komprimierungsart entspricht, und daß jeweils die zugehörige Datenart (z.B. DA5) der Komprimierung zugrundegelegt wird.

4. Verfahren nach einem der Ansprüche 1 bis 3, **dadurch gekennzeichnet,** daß bei einer der ermittelbaren Datenarten (DAx) die Datenzeichen unverändert einem Steuerzeichen (STZ(DA6)) mit einem nachfolgenden Längenzeichen (FL$_{UK}$) zur Kennzeichnung der Anzahl der folgenden unkomprimierten Zeichen angehängt und die auf diese Weise ausgebildeten Zeichenfolgen nachfolgend wie komprimierte Daten behandelt werden.

5. Verfahren nach einem der Ansprüche 1 bis 4, **dadurch gekennzeichnet,** daß Folgen von sich wiederholenden Leerzeichen (LZ) bei der Komprimierung durch ein gesondertes Steuerzeichen (STZ(LZW)) mit einem nachfolgenden Längenzeichen (FL$_{ZW}$) zur Kennzeichnung der Anzahl der aufeinanderfolgenden Leerzeichen ersetzt werden und daß bei der Dekomprimierung anhand des Steuerzeichens und das Längenzeichens eine entsprechende Leerzeichenfolge erzeugt wird.

6. Verfahren nach einem der Ansprüche 1 bis 5, **dadurch gekennzeichnet,** daß Folger von sich wiederholenden Datenzeichen (ZE(E1)) bei der Komprimierung durch ein gesondertes Steuerzeichen (STZ(ZW)) mit einem nachfolgenden Längenzeichen (FL$_{ZW}$) zur Kennzeichnung der Anzahl der aufeinanderfolgenden gleichen Datenzeichen und mit dem dem Längenzeichen folgenden unkomprimierten Datenzeichen (ZE(E1)) ersetzt werden und daß bei der Dekomprimierung anhand der Steuerzeichen und des Längenzeichens das zugehörige Zeichen entsprechend oft in Folge erzeugt wird.

7. Verfahren nach einem der Ansprüche 1 bis 6, **dadurch gekennzeichnet,** daß bei strukturierten Daten mit mehreren Zeilen (1 bis n) und wiederkehrender gleicher Zeichenfolge in einer weiteren Zeile (z.B. i) die sich wiederholende Zeichenfolge bei der Komprimierung durch ein Steuerzeichen (STZ(DUP)) mit nachfolgendem Zeilenkennzeichen (DUPi) für den Zeilenabstand und einem diesem folgenden Längenzeichen (FL$_{DUP}$) zur Kennzeichnung der Anzahl der Zeichen der zu duplizierenden Zeichenfolge ersetzt wird und daß zur Dekomprimierung die bereits dekomprimierten Daten in aufeinanderfolgenden Zeilen gespeichert werden und daß anhand des Steuerzeichens aus der durch das Zeilenkennzeichen (DUPi) angegebenen Zeile (i) die dem Längenzeichen (FL$_{DUP}$) entsprechenden Zeichen nacheinander ausgegeben werden.

8. Verfahren nach einem der Ansprüche 1 bis 7, **dadurch gekennzeichnet,** daß die Zeichenbildung für alle Steuerzeichen (STZ...) wie die für die zu komprimierenden Datenzeichen (ZE(E1)) entsprechend den Prinzipien der Huffman-Codierung erfolgt, während alle übrigen Kennzeichen (FL$_{UK}$, FL$_{ZW}$, FL$_{DUP}$, DUPi) wie unkomprimierte Zeichen bei der Komprimierung unverändert bleiben.

9. Verfahren nach Anspruch 8, **dadurch gekennzeichnet,** daß alle Zeichen der komprimierten Daten (DAT$_{KOMP}$) aus einem oder mehreren gleichlangen Teilzeichen (z.B. 1.HB, 2.HB, 3.HB) gebildet werden, wobei die Anzahl der Bitstellen der Teilzeichen so gewählt ist, daß die unkomprimierten Datenzeichen unmittelbar in zwei Teilzeichen aufteilbar sind.

10. Verfahren nach Anspruch 9, **dadurch gekennzeichnet,** daß alle Steuerzeichen (STZ...) aus jeweils zwei Teilzeichen (1.HB und 2.HB) gebildet werden, während den zu komprimierenden Datenzeichen (ZE(E1)) entsprechend ihrer Häufigkeitsverteilung in einer Datenart (DAx) Zeichen, bestehend aus nur einem (1.HB), aus zwei (1.HB und 2.HB) oder aus drei Teilzeichen (1.HB, 2.HB und 3.HB), zugeordnet werden, wobei die aus drei Teilzeichen (1.HB, 2.HB, 3.HB) bestehenden Zeichen aus einem ersten Teilzeichen (1.HB) mit einer von den ersten Teilzeichen der übrigen Zeichen nicht benutzten Codekombination ("1111") und dem unkomprimierten Datenzeichen als die beiden übrigen Teilzeichen (2.HB und 3.HB) gebildet werden.

11. Anordnung zum Komprimieren und Dekomprimieren von Daten durch Umwandlung der die Daten bildenden und aus Bitfolgen konstanter Länge bestehenden Zeichen (ZE(E1)) in Bitfolgen mit unterschiedlicher Länge und umgekehrt, wobei sich die Länge der Bitfolgen für die umgewandelten Zeichen ($DAT_{KOMP}$) nach der statistischen Häufigkeitsverteilung des Auftretens der Zeichen bei der jeweils zugrundeliegenden Datenart (DA3...DA5) richtet (Huffman-Codierung) und wobei zur Komprimierung von Daten für die einzelnen Zeichen jeweils mehrere, den einzelnen möglichen Datenarten zugeordnete umgewandelte Zeichen zur Verfügung stehen, von denen jeweils die umgewandelten Zeichen der die jeweils günstigsten Übertragungs- bzw. Speicherbedingungen ergebenden Datenart verwendet werden, wobei ein die jeweilige Datenart kennzeichnendes Steuerzeichen den jeweils umgewandelten Zeichen vorangestellt wird, das bei der Dekomprimierung die Wahl der zuständigen Datenart ermöglicht, unter Verwendung von den einzelnen Datenarten entsprechenden Codier- bzw. Decodiertabellen die in Codierungs- bzw. Decodierungsteilspeichern abgelegt sind und deren Einträge anhand der einzelnen Zeichen angesteuert werden können, in Verbindung mit einer Umschaltesteuerung für die Umschaltung auf die der günstigsten Datenart entsprechenden Tabellen,
**dadurch gekennzeichnet,**
daß die Umschaltesteuerung der Komprimierungsanordnung eine gesonderte Teilsteuerung (DA-ST) aufweist, die einen Kennungsspeicher ($TAB_{MARK}$) enthält, der zu jedem zu komprimierenden Datenzeichen (ZE(E3)) einen Eintrag (MARK(E3)) zur Kennzeichnung der jeweils die günstigsten bzw. gleich günstigen Komprimierungsergebnisse liefernden Datenarten (DAx) enthält und der vor der Komprimierung des jeweiligen Datenzeichens durch dieses ansteuerbar ist, um die jeweils zugehörige Datenart (DAx) zu ermitteln, und daß die Einrichtungen zur Auswahl der jeweils zuständigen Codiertabelle und zur Erzeugung eines diese kennzeichnenden Steuerzeichen in einer Komprimiersteuerung (KOMP-ST) abhängig von der von der gesonderten Teilsteuerung (DA-ST) ermittelten Datenart (DAx) steuerbar sind.

12. Anordnung nach Anspruch 11,
**gekennzeichnet durch** eine Auswerteeinrichtung (PLOG) innerhalb der gesonderten Teilsteuerung (DA-ST) für jeweils eine vorgegebene Anzahl (z.B. drei) von nacheinander aus dem Kennungsspeicher ($TAB_{MARK}$) gelesenen Einträgen (MARK(E3)) zur Ermittlung der jeweils günstigsten Datenart (DAx) abhängig von einem vorgegebenen Entscheidungsalgorithmus im Vorlauf zur Komprimierung des jeweils ersten bei der Auswertung berücksichtigten Zeichens (ZE(E1)).

13. Anordnung nach Anspruch 11 oder 12,
**gekennzeichnet durch** eine zweite gesonderte Teilsteuerung (ZW-ST) innerhalb der Komprimierungsanordnung zur Ermittlung von Folgen gleicher Zeichen mit einer Zähleinrichtung zur Ermittlung der Anzahl ($FL_{ZW}$) der gleichen Zeichen in Folge und mit einer Überwachungseinrichtung für Leerzeichen (LZ).

14. Anordnung nach einem der Ansprüche 11 bis 13,
**gekennzeichnet durch** eine dritte Teilsteuerung (DUP-ST) innerhalb der Komprimierungsanordnung zur Ermittlung wiederkehrender Zeichenfolgen in nachfolgenden Zeilen von strukturierten Daten mit Einrichtungen zur Ermittlung einer entsprechenden Zeilenangabe (DUPi) und einer Längenangabe ($FL_{DUP}$) zur Kennzeichnung der Anzahl der Zeichen der zu wiederholenden Zeichenfolge und durch einen vorgeschalteten Schieberegisterspeicher (SREG-SP) mit einer der Anzahl (n) der zu berücksichtigten Datenzeilen entsprechenden Anzahl von in Reihe geschalteten Schieberegistern (REG1 bis REGn) mit jeweils einer der Zeichenanzahl je Zeile entsprechenden Anzahl von Registerstufen.

15. Anordnung nach einem der Ansprüche 11 bis 14,
**gekennzeichnet durch** eine mit allen Teilsteuerungen (DA-ST, ZW-ST, DUP-ST) zusammenarbeitenden Komprimierungssteuerung (KOMP-ST)
  - mit Einrichtungen zur Überwachung der jeweils von den Teilsteuerungen gestellten Arbeitsanforderungen ($DA_{DUP}$, $DA_{ZW}$/LZ, DAx),
  - mit Einrichtungen (STZ-SP) zur Bereitstellung der jeweils benötigten Steuerzeichen (STZ...),

- mit Einrichtungen (TAB$_{KOMP}$) zur Bereitstellung des jeweils komprimierten Zeichens (Z$_{KOMP}$) und
- mit Einrichtungen zur Auswahl der für die Bildung und Ausgabe der komprimierten Daten (DAT$_{KOMP}$) benötigten Zeichen.

16. Anordnung nach Anspruch 15,
**gekennzeichnet durch** in der Komprimierungssteuerung (KOMP-ST) zusätzlich vorhandene Einrichtungen (ZSP) zur Zwischenspeicherung unkomprimiert in Folge weiterzuleitender Datenzeichen (ZE$_{UK}$), zur Ermittlung der Anzahl (FL$_{UK}$) der in Folge weiterzuleitenden unkomprimierten Datenzeichen und zur Ausgabe der zwischengespeicherten Folgen im Anschluß an das Steuerzeichen (STZ(DA6)) und dem Längenzeichen (FL$_{UK}$) als komprimierte Daten (DAT$_{KOMP}$).

17. Anordnung nach einem der Ansprüche 11 bis 16,
**gekennzeichnet durch** eine in der Dekomprimierungsanordnung vorgesehene Dekomprimierungssteuerung (DEK-ST) mit
- Einrichtungen zur Ermittlung der in den komprimierten Daten (DAT$_{KOMP}$) enthaltenen Steuerzeichen (STZ...) in Verbindung mit den den einzelnen Datenarten (DAx) zugeordneten Decodierungsteilspeichern (TAB$_{DEK}$) und mit
- Einrichtungen zur Trennung der in den komprimierten Daten (DAT$_{KOMP}$) enthaltenen direkt auswertbaren Angaben (FL$_{UK}$ bzw.
FL$_{ZW}$ bzw. FL$_{DUP}$, DUPi) und unkomprimierten Datenzeichen von den zur Adressierung der Decodierungsteilspeicher (TAB$_{DEK}$) benötigten Steuerzeichen und komprimierten Zeichen abhängig vom Aufbau der den einzelnen Steuerzeichen (STZ) zugeordneten Zeichenfolgen.

18. Anordnung nach Anspruch 17,
**gekennzeichnet durch** eine der Dekomprimierungssteuerung (DEK-ST) nachgeschaltete Teilsteuerung (ZW-AST) zur Erzeugung von Folgen gleicher Zeichen anhand der von der Decodierungssteuerung (DEK-ST) gelieferten Steuersignale (DA$_{ZW}$,FL$_{ZW}$, LZ bzw. ZE$_{ZW}$).

19. Anordnung nach Anspruch 17 oder 18,
**gekennzeichnet durch** eine der Dekomprimierungssteuerung (DEK-ST) nachgeschaltete Teilsteuerung (DUP-AST) zur Erzeugung von sich in nachfolgenden Zeilen strukturierter Daten wiederholenden Zeichenfolgen anhand der von der Dekomprimierungssteuerung gelieferten Steuersignale (DA$_{DUP}$, FL$_{DUK}$, DUPi) in Verbindung mit einem Schieberegisterspeicher (EREG-SP) mit einer der um 1 verminderten Anzahl (n) der Datenzeilen entsprechenden Anzahl (n-1) von in Reihe geschalteten Schieberegistern (REG1 bis REGn-1) mit jeweils einer der Zeichenanzahl je Zeile entsprechenden Anzahl von Registerstufen, wobei die dekomprimierten Datenzeichen dem Eingang des ersten Schieberegisters (REG1) zugeführt und am Ausgang desselben als dekomprimierte Daten (DAT$_{OUT}$) ausgegeben werden und die Datenzeichen an den Ausgängen aller Schieberegister durch die Teilsteuerung (DUP-AST) auswählbar dem Eingang des ersten Schieberegisters (REG1) zuführbar sind.

## Claims

1. Method for data compression and decompression by converting the characters (ZE(E1)) forming the data and comprising constant-length bit sequences into bit sequences of different lengths and vice versa, in which the length of the bit sequences for the converted characters (DAT$_{KOMP}$) is based on the statistical frequency distribution of the occurrence of the characters for the respective basic data type (DA3 ... DA5) (Huffman coding) and in which, for compressing data, a plurality of converted characters assigned to the individual possible data types are available for the individual characters in each case, of which, in each case the converted characters of the data type producing the respective most favourable transmission or storage conditions are used, a control character indicating the respective data type being placed before the respective converted characters, which control character permits the selection of the relevant data type during the decompression, characterized
- in that an identifier (MARK(E3)) that indicates the data type (DAx) producing the most favourable compression result is assigned to each possible character (ZE(E3)) of the data awaiting compression,
- in that the assigned identifier (MARK(E3)) for the associated most favourable data type (DAx) is determined for each character (ZE(E3)) to be compressed,
- in that it is constantly checked on the basis of the identifiers determined in each case whether the data type (for example DA6) on which the current compression is based matches the data type (for example DA5) indicated by the identifiers, and

- in that in the case of deviation, the further compression is based on the data type (for example DA5) indicated by the identifiers.

2. Method according to Claim 1, characterized in that the change to another data type (DAx) on which to base the compression is made only after determining a predetermined number (for example three) of successive identifiers (MARK(E3)) indicating a more favourable data type.

3. Method according to Claim 2, characterized in that bit combinations (for example "0010") having a number (4) of bit positions corresponding to the number (for example four) of different data types (DA3 to DA6) are used for the identifiers (MARK(E3)) and the bit positions (for example third bit position) corresponding to the respective most favourable data type (for example DA5) or to the respective equally most favourable data types are indicated by one of the two binary values (for example "1"), in that the sequence of binary values (for example "011") produced by successive characters (ZE(E3)) is monitored for each bit position (for example third bit position) and, on the basis of a predetermined decision logic, the sequence of binary values that corresponds to the most favourable compression type is determined, and in that the compression is based on the associated data type (for example DA5) in each case.

4. Method according to one of Claims 1 to 3, characterized in that in the case of one of the data types (DAx) that can be determined, a control character (STZ(DA6)) with a subsequent length character (FL$_{UK}$) for indicating the number of following uncompressed characters is appended to the unchanged data characters, and the character strings formed in this manner are subsequently treated as compressed data.

5. Method according to one of Claims 1 to 4, characterized in that sequences of repeated blanks (LZ) are replaced during the compression by a special control character (STZ(LZW)) with a subsequent length character (FL$_{ZW}$) for indicating the number of successive blanks, and in that a corresponding sequence of blanks is generated during the decompression on the basis of the control character and the length character.

6. Method according to one of Claims 1 to 5, characterized in that sequences of repeated data characters (ZE(E1)) are replaced during the compression by a special control character (STZ(ZW)) with a subsequent length character (FL$_{ZW}$) for indicating the number of successive identical data characters and with the uncompressed data character (ZE(E1)) following the length character, and in that the associated character is successively generated the corresponding number of times during the decompression on the basis of the control characters and the length character.

7. Method according to one of Claims 1 to 6, characterized in that in the case of structured data having a plurality of lines (1 to n) and repeated identical character string in a further line (for example i), the repeated character string is replaced during the compression by a control character (STZ(DUP)) with subsequent line identifier (DUPi) for the line spacing and a following length character (FL$_{DUP}$) for indicating the number of characters in the character string to be duplicated, and in that the already decompressed data are stored in successive lines for decompression, and in that the characters corresponding to the length character (FL$_{DUP}$) are successively output on the basis of the control character from the line (i) indicated by the line identifier (DUPi).

8. Method according to one of Claims 1 to 7, characterized in that the character formation for all control characters (STZ...), like that for the data characters (ZE(E1)) to be compressed, is carried out in accordance with the principles of Huffman coding, while all other identifiers (FL$_{UK}$, FL$_{ZW}$, FL$_{DUP}$, DUPi) remain unchanged during the compression like uncompressed characters.

9. Method according to Claim 8, characterized in that all characters of the compressed data (DAT$_{KOMP}$) are formed from one or more equal-length partial characters (for example 1.HB, 2.HB, 3.HB), the number of bit positions of the partial characters being selected in such a way that the uncompressed data characters can be divided directly into two partial characters.

10. Method according to Claim 9, characterized in that all control characters (STZ...) are formed from two partial characters (1.HB and 2.HB) in each case, while characters comprising only one (1.HB), two (1.HB and 2.HB) or three partial characters (1.HB, 2.HB and 3.HB) are assigned to the data characters (ZE(E1)) to be compressed in accordance with their frequency distribution in a data type (DAx), the characters comprising three partial characters (1.HB, 2.HB, 3.HB) being formed from a first partial character (1.HB) having a code combination ("1111") not used by the first partial characters of the other characters and the uncompressed data character as the two other partial characters (2.HB and 3.HB).

11. Arrangement for data compression and decompression by converting the characters (ZE-(E1)) forming the data and comprising constant-length bit sequences into bit sequences of different lengths and vice versa, in which the length of the bit sequences for the converted characters ($DAT_{KOMP}$) is based on the statistical frequency distribution of the occurrence of the characters for the respective basic data type (DA3 ... DA5) (Huffman coding) and in which, for compressing data, a plurality of converted characters assigned to the individual possible data types are available for the individual characters in each case, of which, in each case the converted characters of the data type producing the respective most favourable transmission or storage conditions are used, a control character indicating the respective data type being placed before the respective converted characters, which control character permits the selection of the relevant data type during the decompression, using coding and decoding tables which correspond to the individual data types and are stored in coding and decoding memory sections respectively, and the entries of which can be addressed on the basis of the individual characters, in connection with a switchover controller for switching over to the tables corresponding to the most favourable data type, characterized in that the switchover controller of the compression arrangement has a separate subcontroller (DA-ST) containing an identifier memory ($TAB_{MARK}$) which contains an entry (MARK(E3)) for indicating the data types (DAx) providing the respective most favourable or equally most favourable compression results for each data character (ZE(E3)) to be compressed, and which can be addressed via the respective data character before the compression thereof for determining the respective associated data type (DAx), and in that the means for selecting the respective relevant coding table and for generating a control character indicating the latter can be controlled in a compression controller (KOMP-ST) depending on the data type (DAx) determined by the separate subcontroller (DA-ST).

12. Arrangement according to Claim 11, characterized by an evaluation means (PLOG) within the separate subcontroller (DA-ST) for a predetermined number (for example three) of entries (MARK(E3)) successively read from the identifier memory ($TAB_{MARK}$) in each case for determining the respective most favourable data type (DAx) depending on a predetermined decision algorithm prior to the compression of the respective first character (ZE(E1)) examined during the evaluation.

13. Arrangement according to Claim 11 or 12, characterized by a second separate subcontroller (ZW-ST) within the compression arrangement for determining sequences of identical characters, having a counting means for determining the number ($FL_{ZW}$) of successive identical characters and having a monitoring means for blanks (LZ).

14. Arrangement according to one of Claims 11 to 13, characterized by a third subcontroller (DUP-ST) within the compression arrangement for determining repeated character strings in successive lines of structured data, having means for determining a corresponding line specification (DUPi) and a length specification ($FL_{DUP}$) for indicating the number of characters in the character string to be repeated, and by an upstream shift register memory (SREG-SP) having a number of series-connected shift registers (REG1 to REGn) corresponding to the number (n) of data lines to be examined, which shift registers have a number of register stages corresponding to the number of characters per line in each case.

15. Arrangement according to one of Claims 11 to 14, characterized by a compression controller (KOMP-ST) which cooperates with all subcontrollers (DA-ST, ZW-ST, DUP-ST),
    - having means for monitoring the job requests ($DA_{DUP}$, $DA_{ZW}$/LZ, DAx) made by the subcontrollers in each case,
    - having means (STZ-SP) for providing the control characters (STZ...) required in each case,
    - having means ($TAB_{KOMP}$) for providing the compressed character ($Z_{KOMP}$) in each case, and
    - having means for selecting the characters required for forming and outputting the compressed data ($DAT_{KOMP}$).

16. Arrangement according to Claim 15, characterized by means (ZSP) additionally present in the compression controller (KOMP-ST) for temporarily storing data characters ($ZE_{UK}$) to be successively forwarded uncompressed, for determining the number ($FL_{UK}$) of uncompressed data characters to be successively forwarded, and for outputting the temporarily stored sequences following the control character (STZ(DA6)) and the length character ($FL_{UK}$) as compressed data ($DAT_{KOMP}$).

17. Arrangement according to one of Claims 11 to 16, characterized by a decompression controller (DEK-ST) provided in the decompression arrangement, having
    - means for determining the control characters (STZ...) contained in the compressed data ($DAT_{KOMP}$) in connection with the decoding memory sections ($TAB_{DEK}$) assigned to the individual data types (DAx), and having
    - means for separating the specifications ($FL_{UK}$ or $FL_{ZW}$ or $FL_{DUP}$, DUPi) that can be directly evaluated contained in the compressed data ($DAT_{KOMP}$) and uncompressed data characters from the control characters required for addressing the decoding memory sections ($TAB_{DEK}$) and compressed characters depending on the structure of the character strings assigned to the individual control characters (STZ).

18. Arrangement according to Claim 17, characterized by a subcontroller (ZW-AST) connected downstream of the decompression controller (DEK-ST) for generating sequences of identical characters on the basis of the control signals ($DA_{ZW}$, $FL_{ZW}$, LZ or $ZE_{ZW}$ respectively) provided by the decoding controller (DEK-ST).

19. Arrangement according to Claim 17 or 18, characterized by a subcontroller (DUP-AST) connected downstream of the decompression controller (DEK-ST) for generating character strings repeated in subsequent lines of structured data on the basis of the control signals ($DA_{DUP}$, $FL_{DUK}$, DUPi) provided by the decompression controller in connection with a shift register memory (EREG-SP) having a number (n-1) of series-connected shift registers (REG1 to REGn-1) corresponding to the number (n) of data lines minus 1, which shift registers have a number of register stages corresponding to the number of characters per line in each case, the decompressed data characters being supplied to the input of the first shift register (REG1) and being output as decompressed data ($DAT_{OUT}$) at the output thereof, and it being possible to supply the data characters at the outputs of all shift registers, selectable by the subcontroller (DUP-AST), to the input of the first shift register (REG1).

Revendications

1. Procédé de compression et de décompression de données par conversion des signaux (ZE-(E1)) formant les données et constitués de séquences de bits de longueur constante, en des séquences de bits ayant différentes longueurs et inversement, du type dans lequel la longueur des séquences de bits pour les signaux ($DAT_{KOMP}$) convertis se règle sur la distribution statistique en fréquences de l'apparition des signaux pour le type de données de base (DA3...DA5) (codage Huffman), et du type dans lequel, pour la compression des données de chacun des signaux, on dispose de plusieurs signaux qui sont convertis, qui sont associés à chaque type de données possible, et parmi lesquels on utilise les signaux convertis du type de données donnant les conditions de transmission ou de mémorisation les plus favorables, et du type dans lequel un signal de commande caractérisant le type de données respectif met en avant le signal converti qui permet, lors de la décompression, le choix du type de données adéquate,
caractérisé par le fait
    - qu'à chaque signal possible (ZE(E3)) des données présentes pour la compression on associe une caractéristique (MARK-(E3)), qui caractérise le type de données (DAx) donnant le résultat de compression le plus favorable,
    - que pour chaque signal (ZE(E3)) à compresser, on détemrine la caractéristique associée (MARK(E3)) pour le type de données (DAx) associé le plus favorable,
    - qu'à partir de la caractéristique déterminée, on contrôle en continu si le type de données (par exemple DA6) se basant sur la compression instantanée concorde avec le type de données (par exemple DA5) indiqué par la caractéristique, et
    - que dans le cas d'une différence, on se base sur le type de données (par exemple DA5) indiqué par la caractéristique pour la compression suivante.

2. Procédé suivant la revendication 1, caractérisé par le fait que l'on effectue le changement sur un autre type de données (DAx), qui est la base de la compression, juste après la détermination d'un nombre prédéterminé (par exemple 3) de caractéristiques (MARK-(E3)) successives et donnant un type favorable de données.

3. Procédé suivant la revendication 2,
caractérisé par le fait que, pour les caractéristiques (MARK(E3)), on utilise des combinaisons de bits (par exemple "0010") avec un nombre (4) de positions binaires correspondant au nombre (par exemple quatre) des différents types de données (DA3 à DA6), et on caractérise les positions binaires (par exemple trois positions binaires), correspondant au type de données (par exemple DA5) le plus favorable ou aux types de données également les plus favorables, par une des deux valeurs binaires (par exemple "1"), que pour chaque position binaire (par exemple trois positions binaires), on contrôle la séquence des valeurs binaires (par exemple "011") obtenue par des signaux successifs (ZE(E3)), et la séquence des valeurs bianires, qui correspond au type de compression le plus favorable et on la détermine à partir d'une logique de décision prédéterminée, et que l'on se base sur le type de données associé (par exemple DA5) pour la compression.

4. Procédé suivant l'une des revendications 1 à 3,
caractérisé par le fait que, pour un des types de données (DAx) susceptible d'être déterminé, on ne change pas les signaux de données, on les applique à un signal de commande (STZ(DA6)) avec un signal (FL$_{UK}$) de longueur directement suivant, pour la caractérisation du nombre de signaux suivants qui ne sont pas compressés, et on traite successivement comme des données compressées les séquences de signaux formées de cette manière.

5. Procédé suivant l'une des revendications 1 à 4,
caractérisé par le fait que l'on utilise des séquences de caractères vides (LZ) se répétant, lors de la compression par un signal de commande particulier (STZ(LZW)) comportant un signal de longueur (FL$_{ZW}$) directement suivant, pour la caractérisation du nombre de caractères vides successifs et que, lors de la décompression, on crée une séquence de caractères vides correspondante à partir du signal de commande et des signaux de longueur.

6. Procédé suivant l'une des revendications 1 à 5,
caractérisé par le fait que l'on utilise des séquences de signaux de données (ZE(E1)) se répétant, lors de la compression par un signal de commande particulier (STZ(ZW)) comportant un signal de longueur (FL$_{ZW}$) directement suivant, pour la caractérisation du nombre de signaux de données identiques et successifs, et comportant le signal de données non comprimé qui suit le signal de longueur, et que, lors de la décompression, on crée le signal associé, de manière correspondante dans la séquence, à partir du signal de commande et du signal de longueur.

7. Procédé suivant l'une des revendications 1 à 6,
caractérisé par le fait que, pour des données structurées comportant plusieurs lignes (1 à n) et comportant des séquences de signaux, identiques et se répétant, dans une autre ligne (par exemple i), on utilise la séquence de signaux se répétant, lors de la compression par un signal de commande (STZ(DUP)) comportant un signal de caractérisation de lignes directement suivant (DUPI) pour l'intervalle de lignes et comportant un signal de longueur (FL$_{DUP}$) suivant ce signal de caractérisation de lignes, pour la caractérisation du nombre de signaux de la séquence à dupliquer et que, pour la décompression, on mémorise dans des lignes successives les données déjà décompressées, et que l'on extrait les signaux, correspondants aux signaux de lignes (FL$_{DUP}$), successivement à partir de la ligne (i) donnée par le signal de caractérisation de ligne (DUPi), en référence au signal de commande.

8. Procédé suivant l'une des revendications 1 à 7 caractérisé par le fait que l'on effectue la formation de signaux pour tous les signaux de commande (STZ...) de la même manière que celle utilisée pour les signaux de données (ZE(E1)) à compresser, en fonction du principe du codage - Huffman, alors que l'on laisse inchangées, lors de la compression, toutes les autres caractéristiques (FL$_{UK}$, FL$_{ZW}$, FL$_{DUP}$, DUPi), comme les signaux non compressés.

9. Procédé suivant la revendication 8 caractérisé par le fait que l'on forme tous les signaux de données compressées (DAT$_{KOMP}$) à partir d'un ou de plusieurs signes partiels de même longueur (par exemple 1.HB, 2.HB, 3.HB), le nombre de positions binaires des signaux partiels étant choisi de telle sorte que les signaux de données non compressés sont susceptibles d'être subdivisés directement en deux signaux partiels.

10. Procédé suivant la revendication 9,
caractérisé par le fait que l'on forme tous les signaux de commande (STZ...) à partir de deux signaux partiels (1.HB et 2.HB), alors que l'on associe les signaux de données à compresser (ZE(E1)), en fonction de leur distribution de fréquence dans un type de données (DAx), à des signaux constitués uniquement d'un (1.HB), de deux (1.HB et 2.HB) ou de trois signaux partiels (1.HB, 2.HB, 3.HB), les signaux constitués de trois signaux partiels (1.HB, 2.HB, 3.HB) étant formés à partir d'un premier signal partiel (1.HB) ayant une combinaison de code ("1111") qui n'est pas utilisée par le premier signal partiel des autres signaux, et à partir du signal de données non compressées, comme les deux autres signaux partiels (2.HB et 3.HB).

11. Dispositif de compression et de décompression de données par conversion des signaux (ZE(E1)) formant les données et constitués de séquences de bits de longueur constante, en des séquences de bits ayant différentes longueurs et inversement, du type dans lequel la longueur des séquences de bits pour les signaux ($DAT_{KOMP}$) convertis se règle sur la distribution statistique en fréquences de l'apparition des signaux pour le type de données de base (DA3...DA5) (codage Huffman), et du type dans lequel, pour la compression des données pour chacun des signaux, on dispose de plusieurs signaux qui sont convertis, qui sont associés à chaque type de données possibles, et parmi lesquels on utilise les signaux convertis du type de données donnant les conditions de transmission ou de mémorisation les plus favorables, et du type dans lequel un signal de commande caractérisant le type de données respectif met en avant le signal converti qui permet, lors de la décompression, le choix du type de données adéquate, moyennant l'utilisation de tableaux de codage et de décodage correspondant à chacun des types de données, les mémorisations partielles de codage et de décodage sont appliquées et leurs chargements peuvent être commandés par chacun des signaux, en liaison avec une commande de commutation pour la commutation sur les tableaux correspondant au type de données le plus favorable,
caractérisé par le fait que la commande de commutation du dispositif de compression comporte une unité de commande partielle particulière (DA-ST), qui comporte une mémoire de caractérisation ($TAB_{MARK}$) qui contient, pour chaque signal (ZE(E3)) de données à compresser, un enregistrement (MARK(E3)) pour la caractérisation des types de données (DAx) fournissant les résultats de compression les plus favorables ou également favorables, mémoire qui est susceptible d'être commandée, avant la compression du signal de données respectif, par ce dernier, afin de déterminer le type de données associé (DAx), et que les dispositifs de sélection des bons tableaux de codage et de création d'un de ces signaux de commande de caractérisation sont susceptibles d'être commandés, dans une unité de commande de compression (KOMP-ST), en fonction du type de données (DAx) déterminé par l'unité de commande partielle particulière (DA-ST).

12. Dispositif suivant la revendication 11 caractérisé par un dispositif d'évaluation (PLOG), situé dans l'unité de commande partielle particulière (DA-ST), pour un nombre prédéterminé (par exemple 3) d'enregistrements (MARK(E3)) lus successivement à partir de la mémoire de caractérisation ($TAB_{MARK}$), pour la détermination du type de données le plus favorable (DAx), en fonction d'un algorithme de décision prédéterminé, au cours de la compression du premier signal (ZE(E1)) considéré lors de l'évaluation.

13. Dispositif selon la revendication 11 ou 12, caractérisé par une deuxième unité de commande partielle particulière (ZW-ST) dans le dispositif de compression, pour la détermination de séquences de signaux identiques comportant un dispositif de comptage pour la détermination du nombre ($FL_{ZW}$) de signaux identiques dans la séquence et comportant un dispositif de contrôle des caractères vides (LZ).

14. Dispositif suivant l'une des revendications 11 à 13, caractérisé par une troisième unité de commande partielle (DUP-ST) dans le dispositif de compression, pour la détermination des séquences de signaux répétitives dans des lignes successives de données structurées, comportant des dispositifs pour la détermination d'une donnée de ligne correspondante (DUPi) et d'une donnée de longueur ($FL_{DUP}$), pour la caractérisation du nombre de signaux de la séquence à répéter, et par l'intermédiaire d'une mémoire (SREG-SP) de registres à décalage montée en aval, comportant un nombre, correspondant au nombre (n) de lignes de données à considérer, de registres à décalage branchés en série (REG1 à REGn) et comportant un nombre d'étages de registres correspondant au nombre de signaux pour chaque ligne.

**15.** Dispositif suivant l'une des revendications 11 à 14,
caractérisé par une unité de commande de compression (KOMP-ST) travaillant conjointement avec toutes les unités de commande partielles (DA-ST, ZW-ST, DUP-ST) comportant

- des dispositifs de contrôle des demandes de travail ($DA_{DUP}$, $DA_{ZW}$/LZ, DAx) établies par les unités de commande partielles,
- des dispositifs (STZ-SP) de mise à disposition des signaux de commande nécessaires (STZ...),
- des dispositifs ($TAB_{KOMP}$) de mise à disposition du signal compressé ($Z_{KOMP}$) et
- des dispositifs de sélection des signaux nécessaires pour la formation et l'émission des données compressées ($DAT_{KOMP}$).

**16.** Dispositif suivant la revendication 15,
caractérisé par des dispositifs (ZSP), présents en supplément dans l'unité de commande de compression (KOMP-ST), pour la mémorisation temporaire de signaux de données ($ZE_{UK}$) non compressés et à transmettre en série, pour la détermination du nombre ($FL_{UK}$) de signaux de données non compressés à transmettre en série et pour l'émission des séries, mémorisées temporairement en liaison avec le signal de commande (STZ(DA6)) et des signaux de longueur ($FL_{UK}$), comme données compressées ($DAT_{KOMP}$).

**17.** Dispositif suivant l'une des revendications 11 à 16,
caractérisé par une unité de commande de décompression (DEK-ST) prévue dans le dispositif de décompression et comportant

- des dispositifs de détermination des signaux de commande (STZ...) contenus dans les données compressées ($DAT_{KOMP}$),en liaison avec les mémoires partielles de décodage ($TAB_{DEK}$) associées à chacun des types de données (DAx), et
- des dispositifs de séparation des données ($FL_{UK}$ ou $FL_{ZW}$ ou $FL_{DUP}$, DUPi) pouvant être évaluées directement et contenues dans les données compressées ($DAT_{KOMP}$) et des signaux de données non compressées, par les signaux de commande nécessaires pour l'adressage de la mémoire partielle de décodage ($TAB_{DEK}$), et des signes compressés en fonction de l'agencement de la séquence de signaux associés à chacun des signaux de commande (STZ).

**18.** Dispositif suivant la revendication 17,
caractérisé par une unité de commande partielle (ZW-AST), branchée en aval à l'unité de commande de décompression (DEK-ST) pour produire des séquences de signaux identiques à partir des signaux de commande ($DA_{ZW}$, $FL_{ZW}$, LZ ou $ZE_{ZW}$) fournis par l'unité de commande de décodage (DEK-ST).

**19.** Dispositif suivant la revendication 17 ou 18,
caractérisé par une unité de commande partielle (DUP-AST), branchée en aval à l'unité de commande de décompression (DET-ST), pour produire des données, se structurant dans les lignes suivantes, de séquences de signaux répétitives, à partir des signaux de commande ($DA_{DUB}$, $FL_{DUK}$, DUPi) fournis par l'unité de commande de décompression, et en liaison avec une mémoire de registres à décalage (EREG-SP) comportant un nombre (n-1) de registres à décalage branchés en série (REG1 à REGn-1) correspondant au nombre (n) diminué de 1 de lignes de données, comportant un nombre d'étages de registres correspondant au nombre de signaux par ligne, les signaux de données compressés étant envoyés à l'entrée du premier registre à décalage (REG1) et étant fournis à la sortie de ce dernier comme données décompressées ($DAT_{OUT}$), et les signaux de données présents aux sorties de tous les registres à décalage étant susceptibles d'être sélectionnés par l'unité de commande partielle (DUP-AST) et susceptibles d'être envoyés à l'entrée du premier registre à décalage (REG1).

FIG 1

FIG 2

FIG 3

| | DAT_KOMP | | | ZE(E1) | | |
|---|---|---|---|---|---|---|
| | 1. HB | 2. HB | 3. HB | DA3 | DA4 | DA5 |
| | 0 0 0 0 | XXXX | XXXX | 0 | E | e |
| | 0 0 0 1 | | | 1 | N | n |
| | 0 0 1 0 | | | 2 | I | i |
| | 0 0 1 1 | | | 3 | T | t |
| | 0 1 0 0 | | | 4 | R | r |
| | 0 1 0 1 | | | 5 | S | s |
| | 0 1 1 0 | | | 6 | D | d |
| | 0 1 1 1 | | | 7 | A | a |
| | 1 0 0 0 | | | 8 | H | h |
| | 1 0 0 1 | | | 9 | O | o |
| | 1 0 1 0 | | | [ | G | g |
| | 1 0 1 1 | | | ] | L | |
| | 1 1 0 0 | XXXX | | . : – | M | m |
| | 1 1 0 1 | 0 0 0 0 | | | C | c |
| | | 0 0 0 1 | | | U | u |
| | | 0 0 1 0 | | | B | b |
| | | 0 0 1 1 | | | K | k |
| | | 0 1 0 0 | | | W | w |
| | | 0 1 0 1 | | | Z | z |
| | | 0 1 1 0 | | | F | f |
| | | 0 1 1 1 | | | P | p |
| | | 1 0 0 0 | | | Ä | ß |
| | | 1 0 0 1 | | | V | S |
| | | 1 0 1 0 | | | Y | E |
| | | 1 0 1 1 | | | Ü | G |
| | | 1 1 0 0 | | | X | M |
| | | 1 1 0 1 | | | J | ä |
| | 1 1 0 1 | 1 1 1 0 | | | Ö | A |
| | 1 1 1 0 | 1 1 1 1 | | + | Ø | B |
| | | 0 0 0 0 | | * | 1 | D |
| | | 0 0 0 1 | | ( | 2 | v |
| | | 0 0 1 0 | | ) | 3 | ü |
| | | 0 0 1 1 | | | 4 | N |
| | | 0 1 0 0 | | D | 5 | I |
| | | 0 1 0 1 | | M | 6 | T |
| | | 0 1 1 0 | | $ | 7 | R |
| | | 0 1 1 1 | | & | 8 | H |
| | 1 1 1 0 | 1 0 0 0 | | = | | |
| | | 1 0 0 1 | | STZ (LZW) | | |
| | | 1 0 1 0 | | STZ (ZW) | | |
| | | 1 0 1 1 | | STZ (DA6) | | |
| | | 1 1 0 0 | | STZ (DUP) | | |
| | | 1 1 0 1 | | STZ (DA3) | | |
| | | 1 1 1 0 | | STZ (DA4) | | |
| | 1 1 1 0 | 1 1 1 1 | | STZ (DA5) | | |
| | 1 1 1 1 | XXXX | XXXX | sonstige ZE (E1) | | |

EP 0 427 884 B1

FIG 4

LZW:  | 1110 : 1001 | FL$_{ZW}$ |

ZW:   | 1110 : 1010 | FL$_{ZW}$ | ZE(E1) |

DA6:  | 1110 : 1011 | FL$_{UK}$ | ZE(E1) ⊦→ |

DUP:  | 1110 : 1100 | DUPi | FL$_{DUP}$ |

DA3:  | 1110 : 1101 | Z$_{KOMP}$ ⊦→ |

DA4:  | 1110 : 1110 | Z$_{KOMP}$ ⊦→ |

DA5:  | 1110 : 1111 | Z$_{KOMP}$ ⊦→ |

|← 1. BYTE →|← 2. BYTE →|← 3. BYTE →|
(STZ......)

FIG 5

TAB$_{MARK}$

ZE(E3) ⟹ MARK(E3)

M3
M2
M1

PLOG

DA-ST

DAx-R

DAx

26

EP 0 427 884 B1

# FIG 6

START DA-ST

DAx = '0000'

1. EINGABETAKT ET$_{KOMP}$ ?  N

J

MARK (E3) → M3

2. EINGABETAKT ET$_{KOMP}$ ?  N

J

M3 → M2 / MARK (E3) → M3

NÄCHSTER EINGABETAKT ET$_{KOMP}$ ?  N

J

M2 → M1 / M3 → M2
MARK (E3) → M3

M = (M1 ∨ M2 ∨ M3) ∧ DAx
BITORIENTIERT

M = '0000' ?  N

J

M = M1 ∧ M2 ∧ M3

M = '0000' ?  N

J

M = M2 ∧ M3

M = '0000' ?  N

J

M = M1 ∧ M3

M = '0000' ?  N

J

M = M3

M ≧ '1000' ?  J

N

DAx = '1000'

M ≧ '0100' ?  J

N

DAx = '0100'

M ≧ '0010' ?  J

N

DAx = '0010'

DAx = '0001'

27

# FIG 7

# FIG 8

# FIG 9

FIG 10A

START KOMP-ST

$Z(J) = 1$
DAV $= '0000'$
DA$_{UK} = 0$

ERZEUGEN DER DREI
ERSTEN EINGABETAKTE
ET$_{KOMP}$

DA$_{ZW} = 1$? — N → (A)

J

DA$_{DUP} = 1$? — N

LZ = 1 — N

J

J

LADEN DKOMP
MIT STZ (DUP)
- - -
DIST = 2

LADEN DKOMP
MIT STZ (LZW)
- - -
DIST = 2

LADEN DKOMP
MIT STZ (ZW)
- - -
DIST = 2

AUSGABE

AUSGABE

AUSGABE

LADEN DKOMP
MIT DUP$_i$
- - -
DIST = 2

LADEN DKOMP
MIT FL$_{ZW}$
- - -
DIST = 2

LADEN DKOMP
MIT FL$_{ZW}$
- - -
DIST = 2

AUSGABE

AUSGABE

AUSGABE

LADEN DKOMP
MIT FL$_{DUP}$
- - -
DIST = 2

LADEN DKOMP
MIT ZEICHEN ZE(E1)
- - -
DIST = 2

AUSGABE

AUSGABE

(B)

NÄCHSTEN EINGABE-
TAKT ET$_{KOMP}$
ERZEUGEN

# FIG 10B

# FIG 10 C

C

$DA_{UK} = 1?$ — N

J

$DA_{UK} = 0$
LADEN DKOMP
MIT $FL_{UK}$
DIST = 2

AUSGABE

AZ = 1

LADEN DKOMP
MIT ZEICHEN
DER ADRESSE
$ZSP_{AD} = AZ$ AUS ZSP
DIST = 2

AUSGABE

$AZ = FL_{UK}$ ? — J

N

AZ = AZ +1

DAV = DAx ? — J

N

DAV = DAx
LADEN DKOMP
MIT STZ (DAx)
DIST = 2

AUSGABE

LADEN DKOMP UND
DIST AUS $TAB_{KOMP}$
ABHÄNGIG VON
ZE (E1) UND DAV

AUSGABE

D

## FIG 11

```
        ╭──────────────────────╮
        │   START ' AUSGABE '   │
        ╰──────────────────────╯
                    │
                    ▼
             ┌─────────────┐
             │   Z(K) = 1  │
             └─────────────┘
                    │
                    ▼
         ┌──────────────────────────┐
         │ LADE S-REG, ABSCHNITT     │
         │ Z(J), AUS DKOMP,          │
         │ ABSCHNITT Z(K)            │
         └──────────────────────────┘
                    │
                    ▼
             ⬡ Z(J) = 2 ? ⬡ ──── N ──┐
                    │                  │
                    J                  ▼
                    │            ┌──────────┐
                    │            │ Z(J) = 2 │
                    │            └──────────┘
                    ▼                  │
         ┌──────────────────────┐      │
         │    AUSGABETAKT        │      │
         │  AT_KOMP ERZEUGEN     │      │
         └──────────────────────┘      │
                    │                  │
                    ▼                  │
             ┌─────────────┐           │
             │   Z(J) = 1  │           │
             └─────────────┘           │
                    │                  │
                    ▼◄─────────────────┘
             ⬡ Z(K) = DIST ? ⬡ ──── J ──┐
                    │                     │
                    N                     │
                    ▼                     │
             ┌───────────────┐            │
             │ Z(K) = Z(K) +1│            │
             └───────────────┘            │
                    │                     │
                    │                     ▼
                    │        ╭──────────────────────╮
                    │        │     FORTSETZUNG       │
                    │        │     VON KOMP-ST       │
                    │        ╰──────────────────────╯
```

34

# FIG 12

# FIG 13A

START DEK-ST

$Z(A) = 1$
$ZEL = 2$
$DAV = DA_{ST}$

EINGABE

LESEN ZEICHEN
UND LÄNGE DIST
AUS TABELLE
$TAB_{DEK}$ MIT ZEICHEN
$DAT_{KOMP}$ AUS Z-REG
ALS ADRESSE

$DIST = 4$ ?  J

FEHLERMELDUNG  N

STOP

ZEICHEN = STZ(DUP) ?  N → A

$ZEL = 2$  J

EINGABE

$DUP_i = Z-REG$

EINGABE

$FL_{DUP} = Z-REG$

$C = 0$ ?  N

$DA_{DUP} = 1$  J

$C = 1$ ?  N

$DA_{DUP} = 0$  J

→ B

→ C

36

EP 0 427 884 B1

# FIG 13B

37

# FIG 13C

# FIG 14

```
                    ┌─────────────────────┐
                    │  START 'EINGABE'     │
                    └──────────┬──────────┘
                               │
                         ╱─────┴─────╲         J
                        ⟨   Z(A) = 2 ? ⟩─────────────────────────┐
                         ╲─────┬─────╱                           │
                               │ N                               │
                               │                          ╱──────┴──────╲        J
                  ┌────────────┴────────────┐            ⟨   ZEL = 2 ?    ⟩──────────────┐
                  │   EINGABETAKT           │             ╲──────┬──────╱                │
                  │   ET_DEK ERZEUGEN       │                    │ N                     │
                  └────────────┬────────────┘                    │        ┌──────────────┴──────────────┐
                               │                                 │        │   Z-REG(1) = E-REG(2)        │
                               │                                 │        └──────────────┬──────────────┘
                         ╱─────┴─────╲         N                 │                       │
                        ⟨   ZEL = 2 ?  ⟩────────┐                │        ┌──────────────┴──────────────┐
                         ╲─────┬─────╱          │                │        │   EINGABETAKT               │
                               │ J              │                │        │   ET_DEK ERZEUGEN           │
                  ┌────────────┴────────────┐   │                │        └──────────────┬──────────────┘
                  │   Z-REG = E-REG         │   │                │                       │
                  └────────────┬────────────┘   │                │        ┌──────────────┴──────────────┐
                               │          ┌──────┴──────┐         │        │   Z-REG(2) = E-REG(1)        │
                               │          │  Z(A) = 2   │   ┌─────┴─────┐  └──────────────┬──────────────┘
                               │          └──────┬──────┘   │  Z(A) = 1 │                 │
                               │     ┌───────────┴──────────┐└─────┬─────┘                │
                               │     │ Z-REG(1) = Z-REG(2)  │      │                      │
                               │     ├─ ─ ─ ─ ─ ─ ─ ─ ─ ─ ─┤      │                      │
                               │     │ Z-REG(2) = E-REG(1)  │      │                      │
                               │     └───────────┬──────────┘      │                      │
                               │                 │     ┌───────────┴──────────┐           │
                               │                 │     │ Z-REG(1) = Z-REG(2)  │           │
                               │                 │     ├─ ─ ─ ─ ─ ─ ─ ─ ─ ─ ─┤           │
                               │                 │     │ Z-REG(2) = E-REG(2)  │           │
                               │                 │     └───────────┬──────────┘           │
                               │                 │                 │                      │
                               ○─────────────────○─────────────────○──────────────────────┘
                               │
                    ┌──────────┴──────────┐
                    │   FORTSETZUNG       │
                    │   VON DEK-ST        │
                    └─────────────────────┘
```

EP 0 427 884 B1

# FIG 15

START DUP-AST

C1 = 0

DA$_{DUP}$ = 1 ?  →N

J

C1 = 1
----
LA = 1

ZEICHEN ZE(i) AUS DUP; ENTSPRECHENDEM REGISTER REG$_i$ AUF AUSGANG AUS 2 SCHALTEN

AUSGABETAKT AT$_{DEK}$ ERZEUGEN

LA = FL$_{DUP}$ ?  →J

N

LA = LA +1

# FIG 16

START ZW-AST

C2 = 0

DA$_{ZW}$ = 1 ?  →N

J

C2 = 1
----
LA = 1

LZ = 1 ?  →J

N

EMPFANGENES ZEICHEN ZE$_{ZW}$ AUF AUSGANG AUS 3 SCHALTEN

LEERZEICHEN AUF AUSGANG AUS 3 SCHALTEN

AUSGABETAKT AT$_{DEK}$ ERZEUGEN

LA = FL$_{ZW}$ ?  →J

N

LA = LA +1